# EUROPEAN PATENT APPLICATION

(11) **EP 4 546 822 A1**
(43) Date of publication of application: **30.04.2025**
(21) Application number: 24208873.0
(22) Date of filing: 25.10.2024
(51) Int. Cl.: H04R 25/00

(54) **EAR IMPRESSION TRIAGE AND IDENTIFICATION OF ANATOMICAL LANDMARKS IN HUMAN EARS**

(30) Priority: 27.10.2023 US 202363593698 P; 21.10.2024 US 202418921167
(71) Applicant: Starkey Laboratories, Inc., Eden Prairie, MN 55344 (US)
(72) Inventor: WEIZMAN, Lior, Eden Prairie, 55344 (US); TRIPTO, Eitamar, Eden Prairie, 55344 (US); O'BRIEN, Parker, Eden Prairie, 55344 (US); REIS JR, Joseph Matthias, Eden Prairie, 55344 (US); FELDSIEN, Craig C., Eden Prairie, 55344 (US)
(74) Representative: Dentons UK and Middle East LLP

(57) **Abstract**

A method comprises obtaining ear modeling data representing a 3-dimensional (3D) impression of an ear surface of an ear of a patient; determining, based on the ear modeling data, values of landmarks of the ear, wherein the landmarks include ear canal landmarks of an ear canal, and determining the values of the landmarks comprises: predicting an ear aperture plane of an aperture of the ear; determining a plurality of cross-sectional planes that are aligned with the ear aperture plane; for each of the cross-sectional planes: determining an intersection boundary of the cross-sectional plane representing a line of intersection between the cross-sectional plane and the ear canal; and determining a centroid of the intersection boundary of the cross-sectional plane; and determining values of the ear canal landmarks based on the centroids.

## Description

This patent application claims the benefit of U.S. provisional patent application 63/593,698, filed October 27, 2023, the entire content of which is incorporated by reference.

### TECHNICAL FIELD

This disclosure relates to hearing instruments.

### BACKGROUND

A hearing instrument is a device designed to be worn on or in a patient's ear. Example types of hearing instruments include hearing aids, earphones, earbuds, telephone earpieces, and other types of devices designed to be worn on or in a patient's ear.

Some hearing instrument manufacturers rely on highly skilled operators to design hearing instruments using three-dimensional modeling software.

When a hearing instrument is produced, these highly skilled operators and/or audiologists may design outer shells of the hearing instruments and arrangement of components of the hearing instruments. Manual modeling and shaping hearing instruments in this way is time consuming, expensive, and can lead to inconsistencies, e.g., due to variations in operator skill level and techniques.

### SUMMARY

In general, this disclosure describes techniques for triaging ear modeling data prior to manufacturing hearing instruments based on the ear modeling data. In some examples, as part of triaging the ear modeling data, a computing system may determine whether the ear modeling data is adequate to generate a device model of a hearing instrument. Furthermore, in some examples, as part of triaging the ear modeling data, the computing system may determine, based on the ear modeling data, whether a hearing instrument device type is feasible for the patient. Additionally, this disclosure describes techniques in which values of landmarks of an ear of a patient are determined and used. In some examples, the values of the landmarks may be used in the triage process.

In one example, this disclosure describes a method comprising: obtaining, by one or more processors implemented in circuitry, ear modeling data representing a 3-dimensional (3D) impression of an ear surface of an ear of a patient; and determining, by the one or more processors, based on the ear modeling data, values of one or more landmarks of the ear, wherein determining the values of the one or more landmarks comprises: predicting, by the one or more processors, an ear aperture plane of the ear; determining, by the one or more processors, a plurality of cross-sectional planes that are aligned with the ear aperture plane; for each of the cross-sectional planes: determining, by the one or more processors, an intersection boundary of the cross-sectional plane representing a line of intersection between the cross-sectional plane and the ear; and determining, by the one or more processors, a centroid of the intersection boundary of the cross-sectional plane; and determining, by the one or more processors, values of the one or more landmarks based on the centroids.

In another example, this disclosure describes a method comprising: obtaining, by one or more processors of a computing system, ear modeling data representing an impression of an ear of a patient; generating, by the one or more processors, based on the ear modeling data, a shell model and one or more component models, the shell model being a model of a shell of a hearing instrument, the component models being models of internal components of the hearing instrument; and determining, by the one or more processors, based on the shell model and the one or more component models, whether there are one or more collisions between the shell model and the one or more component models.

In another example, this disclosure describes a method comprising: obtaining, by one or more processors implemented in circuitry, ear modeling data representing an impression of an ear of a patient; determining, by the one or more processors, based on the ear modeling data, whether the ear modeling data is adequate to generate a device model of a hearing instrument; and outputting, by the one or more processors, an indication of whether the ear modeling data is adequate to generate the device model of the hearing instrument.

In another example, this disclosure describes a method comprising: obtaining, by one or more processors of a computing system, ear modeling data representing an impression of an ear of a patient; determining, by the one or more processors, whether a specific type of hearing instrument is feasible given a shape of the ear of the patient; and outputting, by the one or more processors, an indication of whether the specific type of hearing instrument is feasible given the shape of the ear of the patient.

The details of one or more aspects of the disclosure are set forth in the accompanying drawings and the description below. Other features, objects, and advantages of the techniques described in this disclosure will be apparent from the description, drawings, and claims.

### BRIEF DESCRIPTION OF DRAWINGS

FIG. 1 is a conceptual diagram illustrating an example computing system, in accordance with one or more techniques of the present disclosure.
FIG. 2 is a block diagram illustrating an example triage system, in accordance with one or more techniques of this disclosure.
FIG. 3 is a flowchart illustrating an example operation of an impression analysis system to indicate whether ear modeling data is adequate to generate a device model of a hearing instrument, in accordance with one or more techniques of this disclosure.
FIG. 4 is a conceptual diagram illustrating an example where an ear impression is not adequate to generate a device model of a hearing instrument.
FIG. 5 is a flowchart illustrating an example operation of a device type analysis system to indicate whether a specific type of hearing instrument is feasible given a shape of an ear of a patient, in accordance with one or more techniques of this disclosure.
FIG. 6 is a flowchart illustrating an example operation of a computing system to determine collisions between shell models and component models, in accordance with one or more techniques of this disclosure.
FIG. 7 is a conceptual diagram illustrating example device model in which there are collisions between a component model and a shell model.
FIG. 8 is a block diagram illustrating an example landmarking system, in accordance with one or more techniques of this disclosure.
FIG. 9 is a flowchart illustrating an example operation of a computing system to determine values of landmarks of an ear, in accordance with one or more techniques of this disclosure.
FIG. 10A is a conceptual diagram illustrating an example 3-dimensional model based on an ear impression.
FIG. 10B is a conceptual diagram illustrating example landmarks determined in accordance with techniques of this disclosure.
FIG. 11 is a flowchart illustrating an example operation of the computing system to determine values of landmarks, in accordance with one or more techniques of this disclosure.
FIG. 12 is a conceptual diagram illustrating example cross-sectional planes relative to an ear aperture plane, in accordance with one or more techniques of this disclosure.
FIG. 13 is a block diagram illustrating an example device modeling system, in accordance with one or more techniques of this disclosure.
FIG. 14 is a flowchart illustrating an example process for generating a model of a patient-specific hearing instrument, in accordance with one or more techniques of the present disclosure.
FIG. 15 is a flowchart illustrating an example process for generating a patient-specific hearing instrument model, in accordance with one or more techniques of the present disclosure.
FIG. 16 is a block diagram illustrating example component-placement models, in accordance with one or more techniques of this disclosure.
FIG. 17 is a conceptual diagram illustrating an example structure of a component-placement model, in accordance with one or more techniques of the present disclosure.
FIG. 18 is a conceptual diagram illustrating an example arrangement of components of a hearing instrument, in accordance with one or more techniques of the present disclosure.
FIG. 19A and FIG. 19B are conceptual diagrams illustrating example vent placement, in accordance with one or more techniques of the present disclosure.
FIG. 20 is a conceptual diagram illustrating an example structure of a shell-generation model, in accordance with one or more techniques of the presenting disclosure.
FIG. 21 is a block diagram illustrating an example device-generation model, in accordance with one or more techniques of this disclosure.
FIG. 22A-22B are conceptual diagrams that illustrate a fit of a hearing instrument, in accordance with one or more techniques of this disclosure.
FIGS. 23A-23D are conceptual diagrams that illustrate example retention features, in accordance with one or more techniques of this disclosure.

### DETAILED DESCRIPTION

A hearing instrument is a device designed to be worn on or in a patient's ear. Example types of hearing instruments include hearing aids, hearing protection devices (e.g., custom-made devices to seal the ear and provide electronic hear-through capability), earphones, earbuds, telephone earpieces, and other types of devices designed to be worn on or in a patient's ear. As the term is used herein, a hearing instrument, such as a hearing assistance device, a hearing device, and a hearing instrument, refers to any hearing instrument that is used as a hearing aid, a personal sound amplification product (PSAP), a headphone set, a hearable, a wired or wireless earbud, or other hearing instrument that provides sound to a patient for hearing. In this disclosure, the term "patient" is used to refer to a user of a hearing instrument, even if the user is not using the hearing instrument for any clinical or health-related purpose.

Some hearing instrument professionals take ear impressions of patients and send the raw impressions and/or scans of the raw impressions, along with other patient-specific requirements (e.g., style, features, etc.), to a hearing instrument manufacturer facility. An operator (e.g., a production modeler, audiologist, etc.) at the manufacturing facility may scan the raw impressions or import the scanned impressions into three-dimensional modeling software.

Based on the patient-specific requirements and a set of empirical modelling guidelines known to the operator, the operator may manually design a hearing instrument, for instance, by interacting with the modeling software to create a computer model of an outer shell that can contain all the internal components (e.g., microphones, receiver, circuits, vent, etc.) of the hearing instrument and fit comfortably inside a particular patient's ear. Even with the assistance of three-dimensional modeling software, a skilled operator may spend anywhere from five to fifteen minutes manually creating a model of an outer shell. Once the operator is satisfied with a shell design, a hearing instrument is manufactured, based on the shell design. Afterwards, an operator at a manufacturing facility and/or a hearing instrument professional at a clinic or retail location, may spend additional time further modifying the outer shell of the hearing instrument (e.g., using hand tools) to minimize any actual, or foreseen, patient discomfort.

Manual modeling and shaping hearing instruments in this way is time consuming, expensive, and can lead to inconsistencies, e.g., due to variations in operator skill level and operator techniques. If a patient or professional would like to preview their custom, ear-wearable design before manufacturing, the clinic or retailer must have access to a dedicated modeler, expensive modeling software, and at least five to fifteen minutes of the modeler's time. Furthermore, for custom hearing instruments, such as over-the-counter hearing aids and such, costs and time associated with relying on human operators to manually create hearing instrument designs may not be feasible from a business standpoint and may inject delays in the procurement of hearing instruments, which may be unacceptable to a retailer, professional, or patient. Additional delays may occur if the initial ear impression is inadequate to design a custom hearing instrument for a patient. Furthermore, after the patient receives a hearing instrument, the patient might not be satisfied with the hearing instrument. For instance, the patient might find that the hearing instrument is uncomfortable to wear, falls out, or is not aesthetically satisfactory. In such circumstances, the patient may return the hearing instrument.

Furthermore, a process for manufacturing hearing instruments may include steps of automatically designing the shapes of one or more components of a hearing instrument of hearing instruments based on ear modeling data. Manufacturing systems may automatically manufacture the components in the designed arrangements. While generally efficient, this process may lead to unsatisfactory hearing instruments if the ear impression data is inadequate. For example, the process may lead to hearing instruments that do not fit individual patients well, resulting in the patient's returning the hearing instruments, which leads to waste.

In general, this disclosure describes techniques for automatically evaluating (e.g., triaging) ear impressions and patients prior to designing and fabricating custom hearing instruments for the patients. Evaluating the ear impressions and patient prior to designing custom hearing instruments for the patients may avoid delays, avoid unnecessary involvement of human operators, reduce returns, and increase patient satisfaction. This disclosure further describes techniques for automatically determining values of landmarks of patients' ears. Such landmarks may be used for designing hearing instruments, for research purposes, for understanding aspects of ear features at the population-level (e.g., typical and atypical features, varieties of features, ranges and standard deviations of shapes and sizes), or to gain other insights. Such insights may be used for many purposes, such as designing non-custom hearing instruments or over-the-counter hearing instruments. This knowledge may be leveraged in technical design elements (e.g., generation of machine-learned device sizes, shapes, features, offsets, or fit) to one or more of improve or achieve a functional balance of comfort, sound quality, sealing of the ear, retention in the ear, noise reduction, calculation of a head-related transfer function for sound processing, or any combination thereof. For example, a balance between comfort (e.g., avoiding pain or unpleasant sensation from the presence of the device in the ear) and retention (avoiding situations where the device moves outward away from a preferred placement in the ear) may be achieved based on knowledge derived from a machine-learned model that is trained on a large number of ear geometries, hearing aid shell shapes, or a combination thereof. The techniques described in this disclosure for determining values of the landmarks may improve processing speed and reliability of determining the values of the landmarks. Furthermore, the techniques of this disclosure may be included in a control process of a manufacturing system. A computing system executing the control process may determine, based on the values of the landmarks, whether the ear modeling data is adequate to generate a device model of a hearing instrument. Based on the ear modeling data being adequate to generate the device model, the computing system may generate the device model based on the ear modeling data. The computing system may control a manufacturing system to manufacture the hearing instrument (or one or more components thereof) based on the device model. If the ear modeling data is inadequate, the computing system does not control the manufacturing system to manufacture the hearing instrument. Rather, the computing system may request and receive new ear impression data. In this way, the control process controls the manufacturing system in a way that avoids manufacturing poorly fitting hearing instruments and may ultimately lead to hearing instruments that have better fit for individual users. In some such examples, the control process operates without human intervention. In some examples, the control process allows human review or editing of device models.

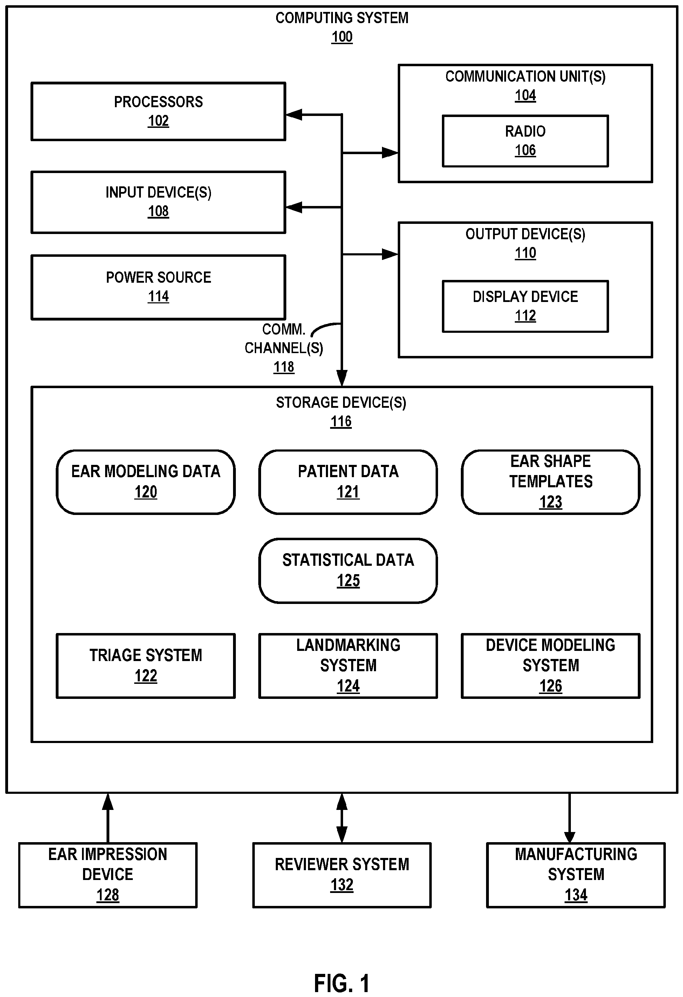

FIG. 1 is a conceptual diagram illustrating an example computing system 100, in accordance with one or more techniques of the present disclosure. In the example of FIG. 1, computing system 100 of FIG. 1 is configured to automatically triage ear impressions and patients, determine values of landmarks, and generate device models for hearing instruments. In other examples, these activities may be performed by different computing systems. Computing system 100 may include one or more computing devices. Example computing devices may include a computer workstation located at a hearing instrument manufacturing facility. In some examples, computing system 100 may include one or more computing devices located at a clinic or other retail facility that fits and sells hearing instruments to patients. In some cases, computing system 100 may include one or more computing devices in a cloud computing environment, and may be accessed remotely via a computing device located at a manufacturing facility, clinic, or other retail facility. In other examples, computing system 100 may include a mobile computing device associated with a patient. FIG. 1 illustrates only one particular example of components of computing system 100, and many other example configurations of computing system 100 may exist.

Computing system 100 may be configured to generate a patient-specific model of a hearing instrument. The hearing instrument may comprise one of various types of devices that are configured to provide auditory stimuli to a patient and that are designed for wear at, on, or near a patient. The hearing instrument may be worn, at least partially, in the ear canal or concha. In any of the examples of this disclosure, each hearing instrument may comprise a hearing assistance device. Hearing assistance devices may include devices that help a patient hear sounds in the patient's environment. Example types of hearing assistance devices may include hearing aid devices, Personal Sound Amplification Products (PSAPs), and so on. In some examples, the hearing instrument is an over-the-counter device, a direct-to-consumer device, or a prescription device. Furthermore, in some examples, the hearing instrument may provide auditory stimuli to a patient that correspond to artificial sounds or sounds that are not naturally in the patient's environment, such as recorded music, computer-generated sounds, sounds from a microphone remote from the patient, or other types of sounds. For instance, the hearing instrument may include a so-called "hearable," an earbud, or another type of device. Some types of hearing instruments provide auditory stimuli to the patient corresponding to sounds from the patient's environment and also artificial sounds. In some examples, the hearing instrument uses a bone conduction pathway to provide auditory stimulation.

The hearing instrument may include a shell that is designed to be worn in the ear and at least partially contains various components of the hearing instrument, such as an electronics component, a receiver, a wax guard, and so on. Such hearing instruments may be referred to as in-the-ear (ITE), in-the-canal (ITC), completely-in-the-canal (CIC), or invisible-in-the-canal (IIC) devices. In some examples, the hearing instrument may be a receiver-in-canal (RIC) hearing-assistance device, which includes a housing worn behind the ear that contains electronic components and a housing worn in the ear canal that contains the receiver. RIC hearing aids may also be referred to as receiver-in-ear (RIE) hearing aids or receiver-in-the-ear (RITE) hearing aids.

The hearing instrument may implement a variety of features that may help the patient hear better. For example, the hearing instrument may amplify the intensity of incoming sound, amplify the intensity of incoming sound at certain frequencies, translate or compress frequencies of the incoming sound, and/or perform other functions to improve the hearing of the patient. In some examples, the hearing instrument may implement a directional processing mode in which the hearing instrument selectively amplifies sound originating from a particular direction (e.g., to the front of the patient) while potentially fully or partially canceling sound originating from other directions. In other words, a directional processing mode may selectively attenuate off-axis unwanted sounds. The directional processing mode may help patients understand conversations occurring in crowds or other noisy environments. In some examples, the hearing instrument may use beamforming or directional processing cues to implement or augment directional processing modes. In some examples, the hearing instrument may reduce noise by canceling out or attenuating certain frequencies. Furthermore, in some examples, the hearing instrument may help the patient enjoy audio media, such as music or sound components of visual media, by outputting sound based on audio data wirelessly transmitted to hearing instrument.

The hearing instrument may include components that enable the hearing instrument to communicate with other devices, such as another hearing instrument, a smartphone, or another type of device. Example types of wireless communication technology include Near-Field Magnetic Induction (NFMI) technology, 900MHz technology, a BLUETOOTH^{™} technology, WI-FI^{™} technology, audible sound signals, ultrasonic communication technology, infrared communication technology, inductive communication technology, or another type of communication that does not rely on wires to transmit signals between devices. In some examples, the hearing instrument uses a 2.4 GHz frequency band for wireless communication.

In the example of FIG. 1, computing system 100 includes one or more processors 102, one or more communication units 104, one or more input devices 108, one or more output devices 110, a power source 114, one or more storage devices 116, and one or more communication channels 118. Computing system 100 may include other components. For example, computing system 100 may include physical buttons, microphones, speakers, communication ports, and so on. Communication channel(s) 118 may interconnect each of processor(s) 102, communication unit(s) 104, input device(s) 108, output device(s) 110, and storage device(s) 116 for inter-component communications (physically, communicatively, and/or operatively). In some examples, communication channel(s) 118 may include a system bus, a network connection, an interprocess communication data structure, or any other method for communicating data. Power source 114 may provide electrical energy to components processor(s) 102, communication unit(s) 104, input device(s) 108, output device(s) 110, and storage device(s) 116.

Storage device(s) 116 may store information required for use during operation of computing system 100. In some examples, storage device(s) 116 have the primary purpose of being a short-term and not a long-term computer-readable storage medium. Storage device(s) 116 may be volatile memory and may therefore not retain stored contents if powered off. Storage device(s) 116 may be configured for long-term storage of information as non-volatile memory space and retain information after power on/off cycles. In some examples, processor(s) 102 on computing system 100 read and may execute instructions stored by storage device(s) 116.

Computing system 100 may include one or more input devices 108 that computing system 100 uses to receive user input. Examples of user input include tactile, audio, and video user input. Input device(s) 108 may include presence-sensitive screens, touch-sensitive screens, mice, keyboards, voice responsive systems, microphones or other types of devices for detecting input from a human or machine.

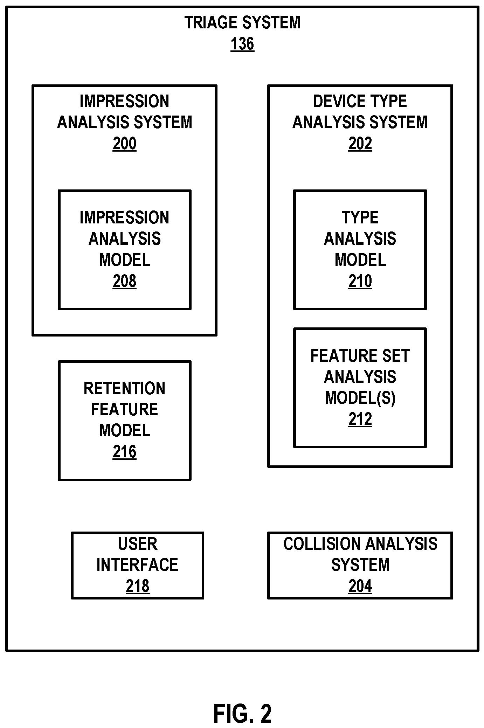

Communication unit(s) 104 may enable computing system 100 to send data to and receive data from one or more other computing devices (e.g., via a communications network, such as a local area network or the Internet). For instance, communication unit(s) 104 may be configured to receive data sent by hearing instruments, receive data generated by a user of hearing instruments, receive and send request data, receive and send messages, and so on. In some examples, communication unit(s) 104 may include wireless transmitters and receivers that enable computing system 100 to communicate wirelessly with the other computing devices. For instance, in the example of FIG. 1, communication unit(s) 104 include a radio 106 that enables computing system 100 to communicate wirelessly with other computing devices, such as hearing instrument (FIG. 1). Examples of communication unit(s) 104 may include network interface cards, Ethernet cards, optical transceivers, radio frequency transceivers, or other types of devices that are able to send and receive information. Other examples of such communication units may include BLUETOOTH^{™}, 3G, 4G, 5G, 6G, and WI-FI^{™} radios, Universal Serial Bus (USB) interfaces, etc. Computing system 100 may use communication unit(s) 104 to communicate with one or more hearing instruments (e.g., hearing instrument (FIG. 1, FIG. 2)). Additionally, computing system 100 may use communication unit(s) 104 to communicate with one or more other remote devices.

Output device(s) 110 may generate output. Examples of output include tactile, audio, and video output. Output device(s) 110 may include presence-sensitive screens, sound cards, video graphics adapter cards, speakers, liquid crystal displays (LCD), or other types of devices for generating output. Output device(s) 110 may include a display device 112.

Processor(s) 102 may read instructions from storage device(s) 116 and may execute instructions stored by storage device(s) 116. Execution of the instructions by processor(s) 102 may configure or cause computing system 100 to provide at least some of the functionality ascribed in this disclosure to computing system 100. As shown in the example of FIG. 1, storage device(s) 116 include ear modeling data 120, patient data 121, a triage system 122, ear shape templates 123, statistical data 125, a landmarking system 124, and a device modeling system 126. In other examples, storage device(s) 116 may store other types of data or other types of computer-executable instructions.

Ear modeling data 120 includes a 3-dimensional (3D) model of an ear of a patient. Although this disclosure refers to a patient, the techniques of this disclosure apply to hearing instruments used for non-medical purposes. The 3D model of the ear of the patient may represent an ear canal of the patient. In some examples, the 3D model of the ear of the patient may include other areas of the ear of the patient, such as the concha, tragus, antitragus, incisura intertragica, antihelix, and so on. In some examples, ear modeling data 120 includes a point cloud containing points on a surface of the patient's ear. A point cloud is a collection of discrete points in space. Each point in a point cloud may be associated with coordinates (e.g., x, y, z Cartesian coordinates, polar coordinates, etc.) that define the position of the point in space. In some examples, ear modeling data 120 represents the surface of the patient's ear using a 3D mesh, or another type of data.

In the example of FIG. 1, computing system 100 may receive ear modeling data 120 from an ear impression device 128. In some examples, ear impression device 128 directly scans the patient's ear, including the patient's ear canal. In some examples, ear impression device 128 may scan a mold formed in the patient's ear.

Patient data 121 may include information regarding individual patients. For example, patient data 121 may include information about the hearing loss of a patient, demographic information about the patient, preferences of the patient, and so on. Ear shape templates 123 may include data that define shapes of ears. Ear shape templates 123 may be generated based on statistical analysis of the ear shapes of many patients.

Triage system 122 may automatically evaluate (e.g., triage) an ear impression and a patient prior to a custom hearing instrument being designed and fabricated for the patient. In this disclosure, references to designing, fabricating, or manufacturing a hearing instrument may apply to designing, fabricating, or manufacturing one or more components of the hearing instrument. Triage system 122 may perform this evaluation during the same session in which ear modeling data 120 for the patient is generated. For instance, the patient may visit an audiologist to obtain an ear impression and during that visit triage system 122 may evaluate the resulting ear modeling data and other aspects of the patient prior to sending the ear modeling data to a designer to design and fabricate a custom hearing instrument for the patient. Triaging ear modeling data and patients prior to designing and fabricating custom hearing instruments may save time for the patients, increase eventual patient satisfaction with their custom hearing instruments, and may reduce costs associated with returned hearing instruments. For example, triage system 122 may present a hearing professional with visual information while the patient is still at a clinic so that problems can be identified and corrected in real time, as opposed to waiting several hours or days for a response from a custom device manufacturer. When a problem is detected, the hearing professional may be able to amend or change the order or do another impression while the patient is still at the clinic and move along the process of designing the hearing instrument.

Landmarking system 124 may identify values of landmarks of a patient's ear. The landmarks of the patient's ear may be biologically, audiometrically, or physically meaningful locations of the patient's ear. A value of a landmark may provide appropriate information about the landmark specific to an individual patient. For instance, a value of a landmark may be a specific location, angle, distance, or other measurement of the landmark. In one specific example, a landmark may be a position of a second bend of the patient's ear canal. In this example, the value of the landmark may be 3-dimensional coordinates of the second bend of the patient's ear canal. The values of the landmarks may be used for various purposes, such as designing custom hearing instruments, improving hearing instrument design, hearing instrument modeling, acoustic transfer functions, acoustic simulations, and more to improve the performance of hearing instruments.

Device modeling system 126 may automatically generate a custom design of a hearing instrument based on ear modeling data 120. In other words, device modeling system 126 may generate one or more custom designs of one or more components of a hearing instrument based on ear modeling data 120. As described in greater detail elsewhere in this disclosure, device modeling system 126 may apply a shell-generation model to generate a shell shape based on ear modeling data. Device modeling system 126 may separately apply one or more component-placement models to determine a position and orientation of one or more components of the hearing instrument. The shell-generation model and the component-placement models may be implemented as machine learning models. In some examples, device modeling system 126 may automatically generate the custom design of the hearing instrument when the triage process is completed successfully (e.g., ear modeling data 120 is adequate, hearing instrument device type is feasible, etc.)

As further shown in the example of FIG. 1, computing system 100 may interact with a reviewer system 132 and a manufacturing system 134. Reviewer system 132 is a computing system used by a user who reviews device models, or other information, prior to the hearing instruments being manufactured. In some examples, reviewer system 132 is used by a hearing professional during a session in which an ear impression of the patient is generated and a triage process is performed. Computing system 100 may be located remote from reviewer system 132.

Manufacturing system 134 may manufacture the hearing instrument. That is, manufacturing system 134 may manufacture or one or more components of the hearing instrument. For example, as part of manufacturing the hearing instrument, manufacturing system 134 may manufacture the shell of the hearing instrument and a component support structure configured to retain the component at the determined position and orientation. For instance, manufacturing system 134 may manufacture a component support structure that is configured to hold the components of the patient-specific hearing instrument in the determined arrangement. Additionally, in some such examples, the components may be attached to the component support structure and immersed in a polymeric bath. A 3D printing apparatus of manufacturing system 134 may use a volumetric 3D printing process, such as holographic lithography or axial lithography to form a shell having the determined shell shape around the components. In other examples, manufacturing system 134 may form the shell (e.g., using an additive manufacturing process or reductive manufacturing process) and a technician may insert the components into the shell. In some examples, triage system 122 may determine, based on the values of landmarks, whether ear modeling data 120 is adequate to generate a device model of a hearing instrument. Based on the ear modeling data being adequate to generate the device model, device modeling system 126 may generate the device model based on ear modeling data 120. Manufacturing system 134 may manufacture the hearing instrument (e.g., the hearing instrument or one or more components of the hearing instrument) based on the device model.

FIG. 2 is a block diagram illustrating an example triage system 122, in accordance with one or more techniques of this disclosure. In the example of FIG. 2, triage system 122 includes an impression analysis system 200, a device type analysis system 202, collision analysis system 204, and a canal shape analysis system 206. In other examples, triage system 122 may include more, fewer, or different components. As mentioned above, triage system 122 performs operations to evaluate ear impressions and patients prior to designing custom hearing instruments for the patients. Each of impression analysis system 200, device type analysis system 202, collision analysis system 204, and canal shape analysis system 206 may perform part of the process of evaluating ear impressions and patients prior to designing custom hearing instruments for patients.

Impression analysis system 200 determines whether ear modeling data 120 is adequate to generate a device model of a hearing instrument. A device model of a hearing instrument may include a model of one or more components of a hearing instrument, such as the shell of the hearing instrument, a faceplate of the hearing instrument, a spine structure for holding other components (e.g., receivers, microphones, processors, etc.) of the hearing instrument, and/or other components of the hearing instrument. Device type analysis system 202 may determine, based on ear modeling data 120, whether a specific type of hearing instrument is feasible given a shape of the ear of the patient. In other words, given the shape of the ear of the patient as indicated by ear modeling data 120 (and/or the quality of ear modeling data 120), device type analysis system 202 may rule out the specific type of hearing instrument (or features thereof) from consideration for the patient. Collision analysis system 200 determines, based on the shell model and the one or more component models, whether there are one or more collisions between the shell model and the one or more component models. These components of triage system 122 are discussed in greater detail below. Triage system 122 may cause display device 112 to display a graphical user interface 218 that includes selectable elements corresponding to types of hearing instruments. In some examples, user interface 218 only shows selectable elements corresponding to types of hearing instruments that are determined to be feasible. In some examples, user interface 218 shows elements corresponding to types of hearing instruments determined to be feasible in positions of greater priority. In some examples, user interface 218 shows elements corresponding to types of hearing instruments determined to not be feasible as unavailable. In this way, certain techniques of this disclosure increase the efficiency of use of the user interface. In response to receiving a selection of a selectable element, triage system 122 may generate a request for provision and/or manufacture of a hearing instrument of a type corresponding to the selected selectable element.

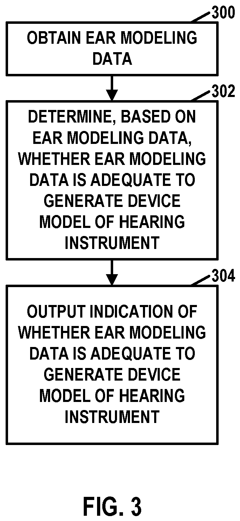

FIG. 3 is a flowchart illustrating an example operation of impression analysis system to indicate whether ear modeling data is adequate to generate a device model of a hearing instrument, in accordance with one or more techniques of this disclosure. In the example of FIG. 3, impression analysis system 200 may obtain ear modeling data 120 representing an impression of an ear of a patient (300). Ear modeling data 120 may include any of the types of data (e.g., point cloud data, 3D image data, etc.) discussed elsewhere in this disclosure for representing an ear impression.

Impression analysis system 200 may determine whether ear modeling data 120 is adequate to generate a device model of a hearing instrument (302). In general, impression analysis system 200 may determine that ear modeling data 120 is not adequate to generate the device model if ear modeling data 120 does not represent enough of the user's ear to generate the device model accurately. For instance, impression analysis system 200 may determine that ear modeling data 120 is not adequate to generate the device model if ear modeling data 120 does not represent points far enough into the patient's ear canal or far enough away from the patient's ear canal. In some examples, the device model may be for a specific type of hearing instrument requested by the patient or professional and impression analysis system 200 may determine whether ear modeling data 120 is adequate to generate to generate a device model of the specific type of hearing instrument.

Impression analysis system 200 may determine whether ear modeling data 120 is adequate to generate the device model in one of a variety of ways. For instance, in some examples, impression analysis system 200 may apply an impression analysis model 208 to ear modeling data 120 to determine whether ear modeling data 120 is adequate to generate the device model. Impression analysis model 208 may be a trained machine learning (ML) model. In such examples, input to the trained ML model may include ear modeling data 120. The trained ML model may be a multi-layer perceptron (MLP) or another type of ML model. The MLP may include two or more fully connected layers of artificial neurons. The MLP may be implemented in a manner similar to that described below with respect to component-placement models 1302, with a single output neuron that indicates a probability that ear modeling data 120 is adequate.

In some examples, to determine whether the ear canal is too short in ear modeling data 120, impression analysis system 200 aligns ear modeling data 120 with an ear shape template 123. Ear shape template 123 represents an ear shape that is not specific to any given patient but may be based on statistical data 125 regarding ear shapes of multiple patients. Impression analysis system 200 may use an iterative closest point (ICP) algorithm to align ear modeling data 120 with ear shape template 123. Impression analysis system 200 may then determine an ear aperture plane. In some examples, an ear aperture plane is indicated in ear shape template 123 and, since ear shape template 123 and ear modeling data 120 are aligned, impression analysis system 200 may use the ear aperture plane indicated by ear shape template 123 as a basis for measuring the depth of the ear canal as represented by ear modeling data 120. If the depth of the ear canal is less than a threshold amount, impression analysis system 200 may determine that ear modeling data is inadequate. The threshold amount may be based on statistical data 125 of ear impressions.

In some examples, impression analysis system 200 may apply a trained ML model to ear modeling data 120 to determine the ear aperture plane. Example details regarding an ML model to determine the ear aperture plane are provided elsewhere in this disclosure. In some examples, training examples used to train the ML model may be based on previously designed hearing instruments (e.g., CIC hearing instruments or other types of hearing instruments) and boundaries between shells of the hearing instruments and faceplates of the hearing instruments are assumed to be the ear aperture planes. This may reduce labor associated with generating training examples, which may increase efficiency and reduce the cost of training the ML model.

In some examples, impression analysis system 200 determines whether ear modeling data 120 defines voids. A void is an open area defined by ear modeling data 120 that does not represent the true shape of the patient's ear. In some examples, to determine whether ear modeling data 120 defines one or more voids, impression analysis system 200 compares ear modeling data 120 to the aligned ear shape template 123 to determine distances between points of ear shape template 123 and corresponding points on surfaces of ear modeling data 120 (e.g., points of ear modeling data 120 on lines orthogonal to the surface of ear shape template 123). Impression analysis system 20 may determine that ear modeling data 120 defines voids if one or more of the distances are greater than a predefined threshold. In some examples, in response to determining that ear modeling data 120 includes one or more voids, impression analysis system 200 modifies ear modeling data 120 to fill the voids.

In some examples, impression analysis system 200 obtains statistical data 125 regarding ear impressions. Statistical data 125 may include statistical distributions of values of landmarks. Impression analysis system 200 may use landmarking system 124 to determine values of the landmarks for the patient based on ear modeling data 120. Additionally, impression analysis system 200 may determine, based on statistical data 125, whether the values of the landmarks for the patient are statistical outliers. A value of a landmark for the patient may be a statistical outlier if the value of the landmark for the patient is a predefined multiple of a standard deviation of the distribution of the values of the landmark. If the value of a landmark for the patient is an outlier, ear modeling data 120 likely includes a defect instead of the patient having an ear shape indicated by the value of the landmark. Hence, if the value of the landmark is a statistical outlier, impression analysis system 200 may determine that ear modeling data 120 is not adequate to generate the device model. In other words, impression analysis system 200 may determine, based on the values of the one or more landmarks being statistical outliers, that ear modeling data 120 is not adequate to generate the device model. In some examples, if impression analysis system 200 determines that ear modeling data 120 is not adequate, impression analysis system 200 may notify one or more expert hearing instrument designers to manually design a hearing instrument for the patient.

In some examples, impression analysis system 200 may compare ear modeling data 120 to ear shape templates 123. For instance, impression analysis system 200 may perform an iterative closest point (ICP) algorithm or other algorithm to align ear shape templates 123 with ear modeling data 120. In this example, impression analysis system 200 may then calculate a difference metric of the ear shape template. The difference metric of an ear shape template may be a measure of how different the ear shape template is from ear modeling data 120. For instance, impression analysis system 220 may calculate a sum of absolute differences, a sum of squared differences, or another similarity measure. If each of the difference metrics are greater than a threshold (or each of the similarity metrics are less than a threshold), impression analysis system 200 may determine that ear impression data 120 is inadequate to generate a device model of a hearing instrument. Thus, impression analysis system 200 may determine whether the ear modeling data is adequate to generate the device model based on the difference or similarity metrics for ear shape templates 123.

In some examples, impression analysis system 200 may detect the presence of hair or wax in ear modeling data 120. Hair or wax may present as jagged discontinuities in ear modeling data 120. Impression analysis system 200 may determine that ear modeling data 120 is inadequate if an amount of hair or wax exceeds a threshold or if a skin surface of the ear cannot be reliably determined from ear modeling data. In some examples, statistical data 125 may be generated that relate probabilities of returns of hearing instruments to the presence of hair or wax in ear modeling data 120.

In some examples, impression analysis system 200 may use values of landmarks determined by landmarking system 124 to determine whether ear modeling data 120 is adequate to generate the device model. For instance, if landmarking system 124 did not determine values for one or more of the landmarks, impression analysis system 200 may determine that ear modeling data 120 is not adequate to generate the device model. For instance, if the values of the landmarks do not include information indicating a location of a concha or anti-helical fold, impression analysis system 200 may determine that ear modeling data 120 is not adequate to generate the device model.

In some examples, impression analysis system 200 determines whether ear modeling data 120 represents a left ear or a right ear. If ear modeling data 120 represents the patient's left ear and a hearing instrument is being generated for the patient's right ear, impression analysis system 200 may determine that ear modeling data 120 is inadequate for purposes of determining the device model of the patient's right ear. Likewise, if ear modeling data 120 represents the patient's right ear and a hearing instrument is being generated for the patient's left ear, impression analysis system 200 may determine that ear modeling data 120 is inadequate for purposes of determining the device model of the patient's left ear. Thus, impression analysis system 200 may determine, based on ear modeling data 120, which of a left or right ear the ear modeling data represents and may determine that the ear modeling data is not adequate to generate the device model if the device model is being designed for an opposite ear of whichever of the left or right ear the ear modeling data represents.

In examples where impression analysis system 200 determines whether ear modeling data 120 represents the left ear or the right ear, impression analysis system 200 may use impression analysis model 208 to determine whether ear modeling data 120 represents the left ear of the right ear. In such examples, impression analysis model 208 may be a MLP or other type of neural network model that receives ear modeling data 120 as input and outputs a prediction regarding whether ear modeling data 120 represents a left ear or a right ear. In some examples, impression analysis system 200 may determine whether ear modeling data 120 represents the left ear or the right ear based on ear shape templates 123. For instance, impression analysis system 200 may obtain predefined ear shape templates 123 for left ears and right ears. Impression analysis system 200 may then attempt to align the ear shape templates 123 with ear modeling data 120, e.g., using an iterative closest point algorithm. Impression analysis system 200 may then determine difference metrics (or similarity metrics) for the aligned ear shape templates 123 that measure differences (or similarity) of the aligned ear shape templates 123 to ear modeling data 120. Impression analysis system 200 may identify an ear shape template 123 with the lowest difference metric (or greatest similarity). For instance, impression analysis system 200 may determine a sum of absolute differences. Impression analysis system 200 may determine that ear modeling data 120 represents a left ear or a right ear depending on whether the identified ear template represents a left ear or a right ear.

Impression analysis system 200 may output an indication of whether ear modeling data 120 is adequate to generate the device model of the hearing instrument (304). For example, impression analysis system 200 may output, for display on display device 112 or reviewer system 132, the indication that ear modeling data 120 is or is not adequate to generate a device model. The indication may request the creation of a new ear impression. In some examples, the indication may be to refer the ear modeling data 120 to a specialist to design the device model of the hearing instrument. In some examples, impression analysis system 200 may cause display device 112 to output user interface 218 for display. User interface 218 may include the indication of whether ear modeling data 120 is adequate to generate the device model. In some examples, user interface 218 includes selectable elements corresponding to different types of hearing instruments. Triage system 136 may generate a request to provision or manufacture a hearing instrument of the type corresponding to a selectable element in response to user input to select the selectable element. In this example, impression analysis system 200 may deprioritize selectable elements corresponding to hearing instruments for which the ear impression data is inadequate. For instance, impression analysis system 200 may gray-out selectable elements corresponding to types of hearing instruments for which ear modeling data 120 is inadequate. This may increase the efficiency of use of the user interface.

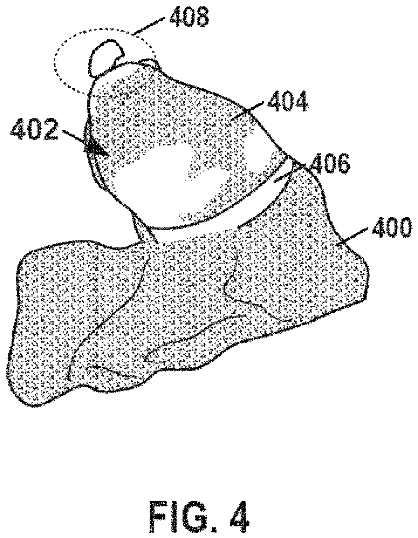

FIG. 4 is a conceptual diagram illustrating an example where an ear impression 400 is not adequate to generate a device model of a hearing instrument. A hearing instrument 402 is overlaid on ear impression 400. Hearing instrument 402 includes a shell 404 and a faceplate 406. As shown in the example of FIG. 4, a portion 408 of shell 404 extends outside of ear impression 400. Portion 408 of shell 404 may extend outside of ear impression 400 because ear impression 400 did not reach sufficiently far into the ear canal of the patient to satisfy a minimum ear canal depth necessary to fit all components of the hearing instrument.

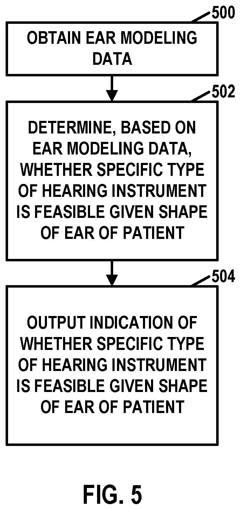

FIG. 5 is a flowchart illustrating an example operation of device type analysis system 202 to indicate whether a specific type of hearing instrument is feasible given a shape of an ear of a patient, in accordance with one or more techniques of this disclosure. In the example of FIG. 5, computing system 100 may obtain ear modeling data 120 representing an impression of an ear of a patient (500). For instance, computing system 100 may obtain ear modeling data 120 from ear impression device 128, e.g., as described above.

Device type analysis system 202 may determine whether a specific type of hearing instrument is feasible given a shape of the ear of the patient (502). There are multiple different types of hearing instruments, such as IIC devices, CIC device, ITC devices, ITE devices, and so on. Some of these device types might not be suitable for a specific patient given anatomical aspects of the specific patient's ears, given the sizes of components (e.g., receivers, processing circuits, batteries, sensors, etc.) required to meet the specific patient's needs. For example, the diameter of the specific patient's ear canal may be too small to accommodate an IIC device, CIC device, or ITC device that has a sufficiently powerful receiver to address the specific patient's hearing loss. In another example, the specific patient's ear canal may bend in such a way that the components cannot be arranged to fit within the specific patient's ear canal.

Device type analysis system 202 may determine whether the specific type of hearing instrument is feasible in one of a variety of ways. For example, device type analysis system 202 may include a type analysis model 210. Type analysis model 210 may be a trained machine learning model that generates output indicating whether the specific type of hearing instrument is feasible for the patient.

In different examples, device type analysis system 202 may provide different types of inputs to type analysis model 210. For instance, in some examples, type analysis model 210 may obtain values of landmarks generated by landmarking system 124 and may obtain patient data 121. In this example, type analysis model 210 may use the values of the landmarks and patient data 121 to determine whether the specific type of hearing instrument is feasible. In other examples, ear modeling data 120 may include a 3D image of the patient's ear and type analysis model 210 may use the 3D image as input. In other examples, ear modeling data 120 may include a 3D point cloud that type analysis model 210 may use as input.

Type analysis model 210 may be implemented in one of a variety of ways. For instance, type analysis model 210 may include a multi-layer perceptron that includes two or more fully connected layers of neurons. This type of neural network may be especially advantageous in examples where the inputs are numerical values, such as examples where the inputs are values of landmarks and other numerical patient data. In some examples, type analysis model 210 may include a convolutional neural network (CNN). The CNN may be especially advantageous in examples where the inputs include a 3D image. In some examples, type analysis model 120 may use device modeling system 126 to generate a device model for a specific type of hearing instrument. Details regarding device modeling system 126 are provided elsewhere in this disclosure. If the device model generated by device modeling system 126 includes collisions between components and the shell, or has other errors, type analysis model 210 may determine that the specific type of hearing instrument is not feasible for the patient.

In other examples, instead of using a trained ML model, such as type analysis model 210, device type analysis system 202 may determine whether the specific type of hearing instrument is feasible for the patient based on a set of predetermined business rules.

Device type analysis system 202 may output an indication of whether the specific type of hearing instrument is feasible given the shape of the ear of the patient (504). Device type analysis system 202 may output the indication in one of a variety of ways. For example, device type analysis system 202 may receive an indication of a preferred device type. In this example, device type analysis system 202 may output an indication, e.g., for display by display device 112 or reviewer system 132, regarding whether the preferred device type is feasible given the shape of the ear of the patient. In some examples, device type analysis system 202 may output, in a graphical user interface, indications for each of a plurality of device types whether the device types are feasible given the shape of the ear of the patient. The user interface may include selectable elements corresponding to the device types, e.g., as described elsewhere in this disclosure.

Hearing instruments within the same hearing instrument type (e.g., IIC, ITC, CIC, etc.) may include different feature sets. Examples of feature sets may include different sets of sensors, different sizes and positions of external user interfaces (e.g., buttons, dials, etc.), different types of receivers, different types of microphones, different types of processing circuitry, different types of batteries (e.g., rechargeable batteries, zinc-air batteries, etc.), radios, antennas, and so on. In some examples, different hearing instrument types can have the same feature sets. Different feature sets may have different space requirements.

Device type analysis system 202 may determine whether a feature set within a hearing instrument type is feasible for a specific patient. For instance, device type analysis system 202 may use a set of feature set analysis models 212 corresponding to different feature sets, similar to type analysis model 210, that generate output that indicates whether the corresponding feature sets are feasible for the patient. Input to feature set analysis models 212 may include values of landmarks, ear modeling data 120, and/or other types of data. In some examples, there may be a single feature set analysis model 212 for each hearing instrument type that indicates which feature sets are feasible for the patient. In some examples, device type analysis system 202 may use device modeling system 126 to attempt to generate a device model for a specific type of hearing instrument with a specific feature set. Details regarding device modeling system 126 are provided elsewhere in this disclosure. If the device model generated by device modeling system 126 includes collisions between components and the shell, or has other errors, type analysis system 202 may determine that the specific type of hearing instrument with the specific feature set is not feasible (or suitable) for the patient. Type analysis system 202 may repeat the device modeling process for multiple hearing instrument types and feature sets until one or more feasible hearing instrument types and feature sets are identified.

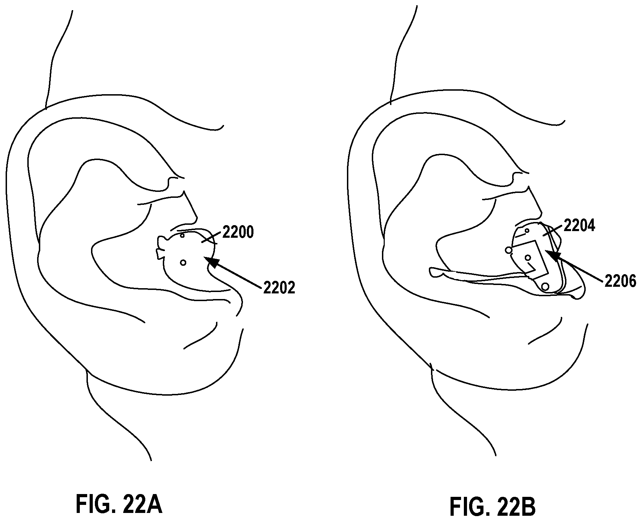

A shape and position of a faceplate of a hearing instrument may differ depending on the feature set. For instance, FIGS. 22A-22B illustrate two different ITC hearing instruments have differently shaped and positioned faceplates due to the hearing instruments having different feature sets. Specific shapes and positions of faceplates may be more aesthetically pleasing than others. For instance, the faceplate 2200 of hearing instrument 2202 in FIG. 22A forms a more continuous surface with the patient's skin and may therefore be more aesthetically pleasing than the faceplate 2204 of hearing instrument 2206 in FIG. 22B. Thus, in some examples, device type analysis system 202 may output a recommendation of which hearing instrument type and feature set may have more aesthetic appeal. For example, device type analysis system 202 may rank feasible hearing instrument types and feature sets according to one or more aesthetic criteria.

In some examples, device type analysis system 202 may determine an angle of a faceplate, a height or width of one or more locations of the faceplate, a shape of the faceplate or distances of locations on the faceplate relative to specific anatomical landmarks (e.g., tragus, helix, intratragal notch, etc.) to estimate a size and protrusion of the hearing instrument. The aesthetic criteria may include the size and protrusion of the hearing instrument. Example aesthetic criteria may include continuity of visible surfaces, etc.

In some examples, device type analysis system 202 may use device modeling system 126 to generate a shell for a hearing instrument. Various features may be attached to a faceplate and may extend further than an outer border of the shell. Device type analysis system 202 may determine a faceplate shape based on the shape of the shell. Device type analysis system 202 may determine aesthetic qualities of the faceplate shape.

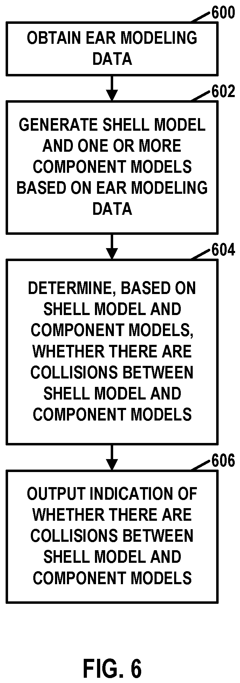

FIG. 6 is a flowchart illustrating an example operation of collision analysis system 204 to determine collisions between shell models and component models, in accordance with one or more techniques of this disclosure. In the example of FIG. 6, computing system 100 may obtain ear modeling data 150 representing an impression of an ear of a patient (600). For instance, computing system 100 may obtain ear modeling data 120 from ear impression device 128, e.g., as described above.

Collision analysis system 204 may generate, based on ear modeling data 120, a shell model and one or more component models (602). The shell model is a model of a shell of a hearing instrument. The component models are models of internal components of the hearing instrument, such as processing circuitry, a battery, a receiver, a wax guard, recharging features, antenna, pull handles, and so on. In some examples, collision analysis system 204 may use device modeling system 126 to generate the shell model and the one or more component models.

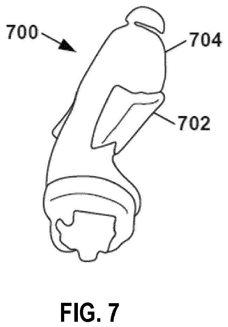

Additionally, collision analysis system 204 may determine, based on the shell model and the one or more component models, whether there are one or more collisions between the shell model and the one or more component models (604). A collision may occur when a component model and the shell model occupy the same point in space. Since it would be impossible for an actual component and the actual shell to occupy the same point in space, the occurrence of a collision may mean that a system (e.g., device modeling system 126) was not able to generate a realistic device model for the patient. The system may not be able to generate a realistic device model for the patient for several reasons, such as an ear geometry that is incompatible with the components. FIG. 7 is a conceptual diagram illustrating example device model 700 in which there are collisions between a component model 702 and a shell model 704. Collision analysis system 204 may determine that there are one or more collisions between the shell model and the one or more component models by representing surfaces of the shell model and one or more component models as mathematical functions, and determining whether there are any points where those mathematical functions are equal. In some examples, shell model 704 comprises a first mesh and component model 702 comprises a second mesh. Collision analysis system 204 may determine whether there are collisions between the shell model by determining whether any point of any of the one or more second meshes is located outside the first mesh.

Collision analysis system 204 may output an indication of whether there are collisions between the shell model and the one or more component models (606). For instance, collision analysis system 204 may output, for display on display device 112 or reviewer system 132, the indication of whether there are collisions between the shell model and the one or more component models. If there are collisions, collision analysis system 204 may prompt a user (e.g., a user of reviewer system 132) to manually design the device model. In some examples, collision analysis system 204 may output, for display, an image such as FIG. 7 to show a user collisions between component models and the shell model. In some examples, collision analysis system 204 may display components that collide with the shell in different colors. For instance, the shell may be displayed in blue and a component that protrudes through the shell may be displayed in red. Furthermore, in some instances, components that could be contained within the shell if the shell were expanded may be displayed in a third color (e.g., yellow).

In some examples, triage system 136 may only forward ear modeling data 150 to device modeling system 126 if there are no collisions. If triage system 136 forwards ear modeling data 150 to device modeling system 126, device modeling system 126 may generate a device model (e.g., a model of one or more components of a hearing instrument) based on the ear modeling data and manufacturing system 134 may manufacture the hearing instrument (e.g., manufacture one or more components of the hearing instrument) based on the device model. In this way, the operation of FIG. 6 is part of a process of controlling manufacturing system 134 in a way that may reduce waste.

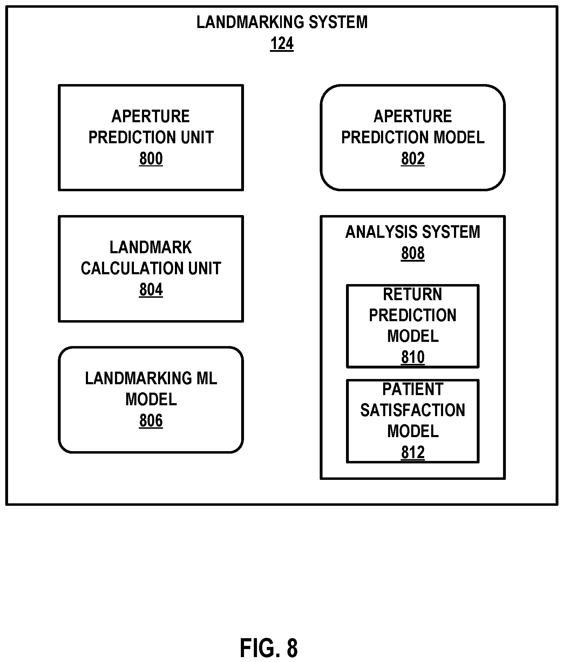

FIG. 8 is a block diagram illustrating an example landmarking system 124, in accordance with one or more techniques of this disclosure. In the example of FIG. 8, landmarking system 124 includes an aperture prediction unit 800, an aperture prediction model 802, a landmark calculation unit 804, and an analysis system 808. In other examples, landmarking system 124 may include more, fewer, or different components.

As described in greater detail below, aperture prediction unit 800 may predict an ear aperture plane of a patient based on ear modeling data 120. In some examples, aperture prediction unit 800 uses aperture prediction model 802 to predict the patient's ear aperture plane. Aperture prediction model 802 may be a trained ML model. In other examples, aperture prediction unit 800 does not apply aperture prediction model 802 to predict the patient's ear aperture plane.

Landmark calculation unit 804 may determine values of landmarks of the patient's ear. In some examples, landmark calculation unit 804 uses the patient's ear aperture plane to determine values of the landmarks. The values of the landmarks may include values of landmarks within an ear canal of the patient and/or outside the ear canal of the patient. Analysis system 808 of landmarking system 124 may use the values of the landmarks for various purposes, such as gaining insights about the patient and about populations of patients. In some examples, the landmarks may include a position of the tympanic membrane and analysis system 808 may determine acoustic performance or parameters of a hearing instrument based on the position of the tympanic membrane.

In some examples, landmark calculation unit 804 may apply a landmarking ML model 806 to determine values of landmarks. The ML model may be trained based on a large number of ear impressions. In different examples, the ear aperture plane may or may not be used as input to the landmarking ML model 806. Landmarking ML model 806 may be implemented in one of various ways. For example, landmarking ML model 806 may be implemented using a convolutional neural network, such as an CNN having a U-net architecture. In some examples, landmarking ML model 806 may be trained (e.g., by computing system 100 or another computing system) based on training examples. The training examples may be generated based on previously made hearing instruments. Boundaries between shells and faceplates of the previously made hearing instruments may be treated as the ear aperture planes.

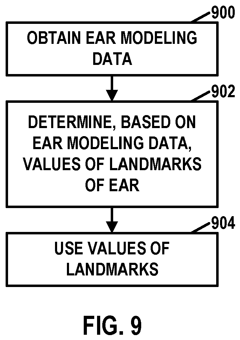

FIG. 9 is a flowchart illustrating an example operation of a computing system to determine values of landmarks of an ear, in accordance with one or more techniques of this disclosure. In the example of FIG. 9, landmarking system 124 may obtain ear modeling data 120 representing a 3D impression of an ear surface of an ear of a patient (900).

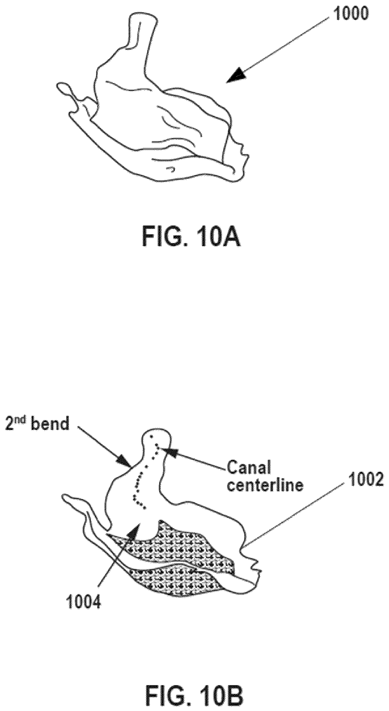

Landmarking system 124 may determine, based on the ear modeling data, values of one or more landmarks of the ear (902). In some examples, the landmarks may include one or more ear canal landmarks of an ear canal of the ear. The ear canal landmarks are landmarks within the patient's ear canal. Example ear canal landmarks include a location of a first bend of the ear canal, a location of a second bend of the ear canal, an angle of the first bend of the ear canal, an angle of the second bend of the ear canal, a center line of the ear canal, a length of the ear canal, or a width of the ear canal. Landmarking system 124 may determine the values of the landmarks in one of a variety of ways. FIG. 10, which is described in greater detail below, illustrates one example process for determining the values of some types of landmarks.

In some examples, the landmarks may include outer ear landmarks that are outside of the patient's ear canal. Example outer ear landmarks may include a position of a helix of the ear, a position of a tragus of the ear, or a radius of the concha at various locations. In some examples, landmarking system 124 determines the outer ear landmarks and not the ear canal landmarks. In other example, landmarking system 124 determines the inner ear landmarks and not the ear canal landmarks. In other examples, landmarking system 124 determines both the ear canal landmarks and the outer ear landmarks.

After landmarking system 124 determines the values of the landmarks, computing system 100 may use the values of the one or more landmarks (904). Computing system 100 may use the values of the one or more landmarks in one or more ways. For example, triage system 122 may determine, based on the values of the one or more landmarks, whether one or more hearing instrument types are suitable for the patient. Triage system 122 may output one or more indications of whether the one or more hearing instrument types are suitable for the patient.

In some examples of using the values of the landmarks, analysis system 808 may calculate statistical data 125 regarding ears of a population of patients based in part on the values of the landmarks. Example statistical data 125 may include averages of values of the landmarks within the population, distributions of values of the landmarks within the population, maximum and minimum torsion metrics (i.e., measure of the "twistiness" of the ear canals) or distributions thereof, average volumes of conchas, and so on.

Analysis system 808 may use statistical data 125 in one or more ways. For example, analysis system 808 may determine, based on statistical data 125, a correlation between observed values of the landmarks in the population and returns of hearing instruments provided to the patients in the population. For instance, analysis system 808 may determine probability values of a hearing instrument being returned given different combinations of values of the landmarks. In the context of this disclosure, a return of a hearing instrument may refer to a patient physically returning the hearing instrument to a provider (or other party). Furthermore, statistical data 125 may be granular to a level of device type and/or feature set. Thus, analysis system 808 may be able to determine, based on statistical data 125, correlations between observed values of landmarks and returns of specific types of hearing instruments (and/or returns of hearing instruments with specific feature sets). A patient may return a hearing instrument because the patient is dissatisfied with the hearing instrument, the hearing instrument is uncomfortable, the hearing instrument falls out of the patient's ear, the patient is not using the hearing instrument, or for other reasons.

In some examples, statistical data 125 may include information about what types of hearing instruments and/or feature sets patients obtain after returning a hearing instrument. This information may be useful in training type analysis model 210 and/or feature set analysis models 212.

A patient might return a hearing instrument due to retention problems, such as the hearing instrument being prone to falling out of the patient's ear or otherwise moving to an incorrect position within the patient's ear. Accordingly, in some examples, analysis system 808 may determine on a correlation between observed values of the landmarks of patients in a population and returns of hearing instruments due to retention problems. Triage system 122 (e.g., device type analysis system 202) may determine, based on the correlation and the values of the landmarks of a specific patient whether the patient is likely to return specific types of hearing instruments due to retention problems. In some examples, if the probability of the patient returning a specific type of hearing instrument due to retention problems is greater than a predefined threshold, triage system 122 may output an indication that the specific type of hearing instrument is not feasible for the patient. In some examples, triage system 122 may determine, based on the values of the landmarks of the patient's ear, whether to recommend a hearing instrument that includes a retention feature. For instance, triage system 122 may determine, based on the values of the landmarks of the patient's ear and based on statistical data 125 indicating a correlation between values of landmarks and returns due to retention problems, a probability of the patient returning the hearing instrument due to a retention problem. If the probability of the patient returning a specific type of hearing instrument (e.g., a CIC hearing instrument, an ITC hearing instrument, etc.) due to retention problems is greater than a predefined threshold, triage system 122 may output a recommendation that the hearing instrument include a retention feature (e.g., a "canal lock") that braces the hearing instrument into an appropriate position within the patient's ear. A retention feature may be rigid or semi-rigid. A retention feature may be formed of a solid plastic, silicone, or other material or combination of materials. In some examples, a retention feature is made of a clear material to reduce visibility of the retention feature. In some examples, the designs of hearing instruments generated by device modeling system 126 may be limited to those that have or do not have a retention feature, depending on the recommendation. Thus, manufacturing system 134 may manufacture one or more components of a hearing instrument that have or do not have the retention feature, depending on the recommendation.

In some examples where triage system 122 determines that the hearing instrument should include a retention feature, triage system 122 (e.g., impression analysis system 200) may determine whether ear modeling data 120 includes sufficient information for device modeling system 126 to predict a shape of the retention feature. For example, triage system 122 may determine whether the values of landmarks determined by landmarking system 124 include values of landmarks of the outer ear (e.g., tragus, helix, etc. If such landmark values were not determined, triage system 122 may determine that ear modeling data 120 does not include sufficient information for device modeling system 126 to predict the shape of the retention feature. In other examples, any of the examples provided in this disclosure with respect to impression analysis system 208 may be adapted to determine whether ear modeling data 120 includes sufficient information for device modeling system 126 to predict the shape of the retention feature.

If triage system 122 determines that ear modeling data 120 does includes sufficient information for device modeling system 126 to predict the shape of the retention feature, device modeling system 126 may determine the shape of the retention feature as part of generating a device model of the hearing instrument. In other words, device modeling system 126 may generate a device model for a custom hearing instrument that includes the retention feature.

A hearing instrument may have one of several different types of retention features. Example types of retention features include retention features that brace the hearing instrument against a helix of the patient's ear, retention features that brace the hearing instrument against a concha bowl of the patient's ear, retention features that brace the hearing instrument against an antitragus of the patient's ear, retention features that have hook-like shapes, retention features that have loop-like shapes, and so on.

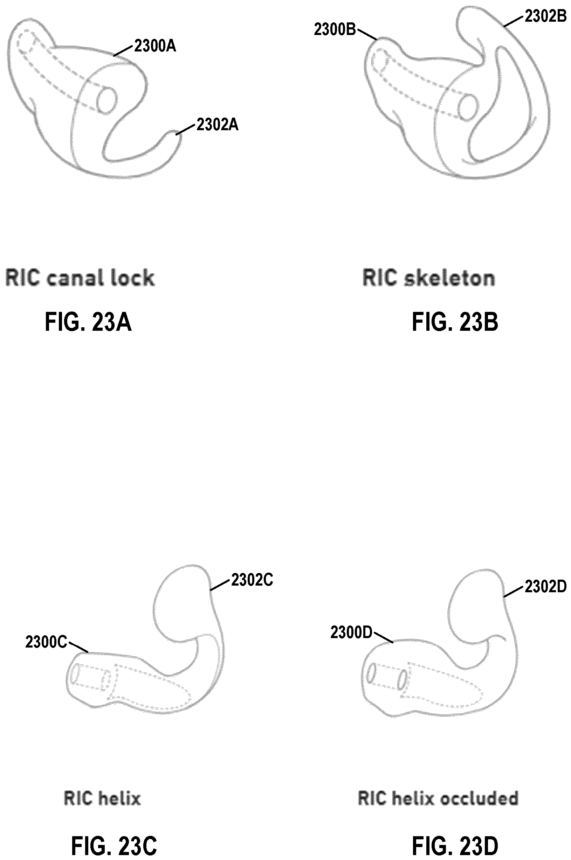

Examples of different retention features are illustrated in FIGS. 23A-23D. In other words, FIGS. 23A-23D are conceptual diagrams that illustrate example retention features, in accordance with one or more techniques of this disclosure. Specifically, FIG. 23A shows a RIC hearing instrument 2300A having a canal lock retention feature 2302A. FIG. 23B shows a RIC hearing instrument 2300B having a "skeleton" style retention feature 2302B which has a loop-like shape. FIG. 23C shows a RIC hearing instrument 2300C having a retention feature 2302C that braces RIC hearing instrument 2300C against a helix of the patient's ear. FIG. 23D shows a RIC hearing instrument 2300D having a retention feature 2302D that is braces RIC hearing instrument 2300D against a helix of the patient's ear and is occluded.

In some examples, triage system 122 may determine a recommended type of retention feature for a hearing instrument of a specific patient. Thus, a recommendation that a hearing instrument include a retention feature may include a recommendation for a specific type of retention feature. Triage system 122 may determine the recommended type of retention feature based on the values of landmarks of the patient's ear, based directly on ear modeling data 120, and/or other types of data. For example, triage system 122 may apply a trained retention feature ML model 216 that indicates a recommended type of retention feature. Retention feature ML model 216 may include an output neuron for each type of retention feature (or no retention feature). Retention feature ML model 216 may be implemented as a MLP with one or more hidden layers. In some examples, retention feature ML model 216 is implemented as a *k*-means clustering model or support vector machine (SVM), with different clusters corresponding to different types of retention features (or no retention feature). Retention feature ML model 216 may be trained based on training examples that indicate landmark values and types of retention features a human designed for the resulting hearing instrument. In some examples, the type of retention feature is determined internally as part of device modeling system 126 generating a device model of the hearing instrument. The recommended type of retention feature may be a smallest and/or least visible type of retention feature that would address the retention problem, e.g., to improve an aesthetic appearance of the hearing instrument.

In some examples, if triage system 122 determines that a patient is likely to experience a potential retention problem, triage system 122 may refer the patient to a human specialist who may redesign the shell or faceplate shape to reduce the potential retention problem. In some examples, if triage system 122 determines that the patient is likely to experience a potential retention problem, triage system 122 may use device modeling system 126 to design a different device model.

In some examples, analysis system 808 may generate, based on statistical data 125 and the values of landmarks, a recommendation regarding whether a specific type of hearing instrument is suitable for the patient. For example, example types of hearing instruments may include IIC, CIC, ITC, and ITE hearing instruments. In this example, analysis system 808 may determine, based on statistical data 125 and the values of the landmarks, analysis system 808 may determine which, if any, of an IIC hearing instrument, CIC hearing instrument, an ITC hearing instrument, or an ITE hearing instrument to recommend to the patient. In an example where analysis system 808 has determined probability values of a return given different combinations of values of the landmarks, analysis system 808 may determine a probability value of a return given the combination of values of the landmark of this patient. If the probability value is above a predetermined threshold, analysis system 808 (or triage system 122) may output an indication that the specific type of hearing instrument is not suitable (e.g., feasible) for the patient.

Analysis system 808 may output the recommendation for display. For instance, analysis system 808 may output an indication of which type of hearing instrument is suitable for the patient, may output an indication that a particular type of hearing instrument is or is not suitable for the patient, or may provide other output or perform other actions based on the recommendation.

In some examples, analysis system 808 may apply a return prediction model 810 to predict, based on the values of the landmarks, whether the patient will return a hearing instrument provided to the patient. Return prediction model 810 may receive the values of the landmarks as input and may output a prediction regarding whether the patient will return a hearing instrument. Return prediction model 810 may be a trained ML model, such as a deep neural network, k-means clustering model, support vector machine, or other type of ML model.

In some examples, analysis system 808 may apply a patient satisfaction model 812 that predicts patient satisfaction. In some examples, input to patient satisfaction model 812 may include values of landmarks, ear modeling data 120, or other data. In some examples, input to patient satisfaction model 812 may include a hearing instrument type and feature set. Patient satisfaction model 812 may be implemented as a trained ML model, such as a deep neural network, k-means clustering model, support vector machine, or other type of ML model. Patient satisfaction may include satisfaction with functionality, retention, size, shape, and aesthetic appearance. Analysis system 808 may determine patient satisfaction for multiple hearing instrument types and/or feature sets to determine which hearing instrument type and/or feature set is likely to provide the greatest patient satisfaction.

The geometry of the patient's ear canal can change depending on whether the patient's jaw is open or closed. Thus, a hearing instrument designed based on landmark values determined based on a closed-jaw ear impression may not be comfortable when the patient's jaw is closed, or vice versa. Thus, in some examples of this disclosure, landmarking system 124 may determine values of the landmarks when the patient's jaw is open and determine values of the landmarks when the patient's jaw is closed. For instance, ear modeling data 120 (i.e., first ear modeling data) may represent a 3D impression of the ear surface while a jaw of the patient is open and landmarking system 124 may obtain second ear modeling data representing a 3D impression of the ear surface the jaw of the patient is closed. Landmarking system 124 may determine, based on the first ear modeling data, first values of the landmarks. Additionally, landmarking system 124 may determine, based on the second ear modeling data, second values of the landmarks.

Computing system 100 may use the first values (e.g., open-jaw values) of the landmarks and the second values (e.g., closed-jaw values) of the landmarks for one or more purposes. In some examples, analysis system 808 may calculate statistical data 125 regarding ears of a population of patients based in part on the first values of the landmarks and the second values of the landmarks. Example statistical data 125 may include averages of values of the landmarks within the population, distributions of values of the landmarks within the population, and so on.

Analysis system 808 may use the statistical data 125 for various purposes. For instance, in some examples, analysis system 808 may determine, based on statistical data 125, a correlation between observed values of the landmarks in the population and returns of hearing instruments provided to the patients in the population. If the first and second values of landmarks of the patient are correlated with a high probability of hearing instrument return, analysis system 808 may notify a technician or suggest alternatives. In some examples, analysis system 808 may generate, based on statistical data 125, the first values of landmarks, and the second values of the landmarks, a recommendation regarding whether a specific type of hearing instrument is suitable for the patient. For example, the recommendation may indicate that an IIC hearing instrument is suitable for the patient, that a CIC hearing instrument, that an ITC hearing instrument is suitable for the patient, that an ITE hearing instrument is suitable for the patient, or other type of hearing instrument is suitable for the patient.

FIG. 10A is a conceptual diagram illustrating an example 3-dimensional model 1000 based on an ear impression. FIG. 10B is a conceptual diagram illustrating example landmarks 1002 determined in accordance with techniques of this disclosure. In the example of FIG. 10B, the landmarks include a canal centerline and a second bend of the ear canal. In addition, FIG. 10B shows a predicted aperture 1004 of the ear canal.

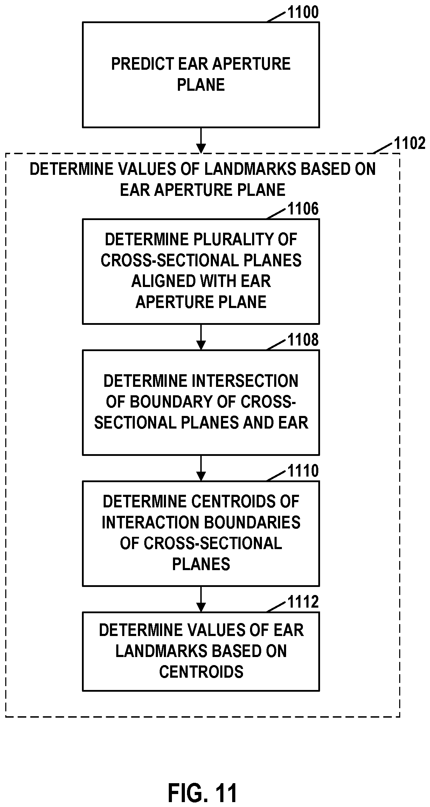

FIG. 11 is a flowchart illustrating an example operation of computing system 100 to determine values of landmarks, in accordance with one or more techniques of this disclosure. In the example of FIG. 11, aperture prediction unit 800 predicts an ear aperture plane of the patient (1100). The aperture of the ear canal is the boundary between the ear canal and the concha of the ear. The ear aperture plane is an imaginary plane aligned with the aperture of the ear canal. Various landmarks may be defined with reference to the ear aperture plane. For example, a depth of the ear canal may be defined as a distance from the ear aperture plane to the tympanic membrane. In another example, an angle of a first bend of the ear canal may be defined as an angle between a first line segment that passes through the center of the ear aperture plane and a center of the first bend, and a second line segment that passes through the center of the first bend and a center of the second bend of the ear canal. In some examples, landmarks may include aspects outside of the ear aperture plane, such as a distance between a width of the concha at various distances from the ear aperture, a position of the tragus, a position of the antihelix, and so on.

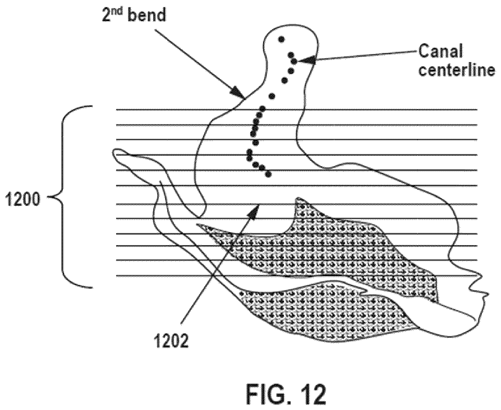

Aperture prediction unit 800 may predict the patient's ear aperture plane in one of a variety of ways. For instance, aperture prediction unit 800 may apply an aperture prediction model 802, which is a trained ML model, to ear modeling data 120 to predict the ear aperture plane. For example, aperture prediction model 802 may be implemented using a point cloud-based neural network model. A point cloud is a collection of discrete points in space. Each point in a point cloud may be associated with coordinates (e.g., x, y, z Cartesian coordinates, polar coordinates, etc.) that define the position of the point in space. In this example, ear modeling data 120 may include a first point cloud representing the ear surface. Aperture prediction unit 800 may provide the first point cloud as input to the trained ML model. Aperture prediction unit 800 may obtain a second point cloud representing the ear aperture plane as output of the trained ML model. FIG. 12, which is discussed in more detail below, illustrates an example point cloud-based neural network model that predicts the ear aperture.

In some examples, storage device 116 store a plurality of ear shape templates 123 (FIG. 1). In some examples, ear shape templates 123 may be generated based on a statistical analysis of the ears of many patients. In some examples, ear shape templates 123 are shapes of previously made custom hearing instruments. The ear aperture planes of each of ear shape template may be predefined in each of ear shape templates 123. In some examples, the ear aperture planes may be predefined manually be a person in one or more of ear shape templates 123. In some examples, such as examples where ear shape templates 123 are shapes of previously made custom hearing instruments, aperture prediction unit 800 may assume that the ear aperture planes are aligned with boundaries between the shells and faceplates of the previously made custom hearing instruments. This assumption may simplify the process of generating ear shape templates 123. To predict the ear canal aperture of a specific patient, aperture prediction unit 800 may compare ear shape templates 123 to ear modeling data 120 for the specific patient to determine which of ear shape templates 123 can be best aligned with ear modeling data 120. For example, aperture prediction unit 800 may perform an iterative closest point (ICP) algorithm to align an ear shape template with ear modeling data 120. In this example, aperture prediction unit 800 may then calculate a difference metric of the ear shape template. The difference metric of an ear shape template may be a measure of how different the ear shape template is from ear modeling data 120. For instance, aperture prediction unit 800 may calculate a sum of absolute differences, a sum of squared differences, or another similarity measure. Aperture prediction unit 800 may then select one of ear shape templates 123 based on the difference metric of ear shape templates 123, e.g., an ear shape template with a smallest difference metric. In other examples, aperture prediction unit 800 may calculate a similarity metric that measures a similarity of the ear shape template and ear modeling data 120 and select one of ear shape templates 123 based on the similarity measure. Aperture prediction unit 800 may use the predefined ear canal aperture of the selected ear shape template as the predicted ear canal aperture of the patient. In other words, aperture prediction unit 800 may predict the patient's ear aperture plane based on the predefined ear aperture plane of the selected ear shape template. Determining the ear canal aperture of the patient in this way may avoid the need to perform complicated and expensive training of a neural network model to predict the patient's ear aperture plane.

Landmark calculating unit 804 may determine values of landmarks based on the ear aperture plane (1102). In the example of FIG. 11, as part of determining values of the landmarks, landmark calculation system 804 may determine a plurality of cross-sectional planes that are aligned with the ear aperture plane (1106). In other words, the cross-sectional planes are parallel to the ear aperture plane. The cross-sectional planes may be spaced apart by equal distances. FIG. 12 is a conceptual diagram illustrating example cross-sectional planes 1200 relative to an ear aperture plane 1202, in accordance with one or more techniques of this disclosure.

For each of the cross-sectional planes, landmarking system 124 may determine an intersection boundary of the cross-sectional plane representing a line of intersection between the cross-sectional plane and the ear canal (1008). In other words, the line indicates where the cross-sectional plane meets the surface of the ear canal. Thus, each of the intersection boundaries may be a 2-dimensional closed curve. In some examples, the cross-sectional plane does not intersect the ear canal, such as when the cross-sectional plane is medial to the patient's tympanic membrane.

Furthermore, for each of the cross-sectional planes, landmark calculation unit 804 may determine a centroid of the intersection boundary of the cross-sectional plane (1110). The centroid of the intersection boundary may be a point where the intersection boundary would balance if suspended from that point. Landmark calculation unit 804 may determine the centroid of the intersection boundary using integration or using Green's theorem.

Landmark calculation unit 804 may determine values of the one or more landmarks based on the centroids (1112). For example, landmark calculation unit 804 may perform a regression analysis to define a curve through the centroids. This curve may be referred to as the midline curve of the ear canal or canal centerline. The landmarks may include a position of a first bend of the ear canal and a position of a second bend of the ear canal. Landmark calculation unit 804 calculate one or more partial derivatives of the midline curve and identify 0-intercepts of the one or more partial derivatives to identify the first bend and second bend of the ear canal. In some examples, the landmarks may include an angle of a bend (e.g., the first bend or the second bend). To determine the angle of the bend, landmark calculation unit 804 may perform a linear regression of centroids before the bend, perform a linear regression of centroids after the bend, and determine an angle between the resulting two lines. In some examples, the landmarks may include a depth (or length) of the ear canal. To determine the depth of the ear canal, landmark calculation unit 804 may determine a distance from a centroid of the ear aperture plane to a first cross-sectional plane that does not intersect the ear canal.

In some examples, landmark calculation unit 804 may treat the canal centerline as a space curve and calculate curvature and torsion parameters of the canal centerline. Triage system 122 may use the curvature and torsion parameters to, e.g., determine whether one or more types of hearing instruments are feasible for the patient. For instance, too much curvature or torsion within the ear canal may prevent specific hearing instrument components from being placed within the patient's ear canal.

In some examples, landmark calculation unit 804 may use the cross-sectional planes to determine values of landmarks outside (i.e., lateral) to the ear aperture plane. For instance, landmark calculation unit 804 may use the intersection boundaries to determine a shape or diameter of the patient's concha at various levels. In some examples, landmark calculation unit 804 may use a set of intersection boundaries to the determine a volume of the concha. In some examples, landmark calculation unit 804 may use the intersection boundaries to identify positions of one or more of an intratragic notch, an antihelix, an antitragus, a tragus, or other parts of the outer ear.

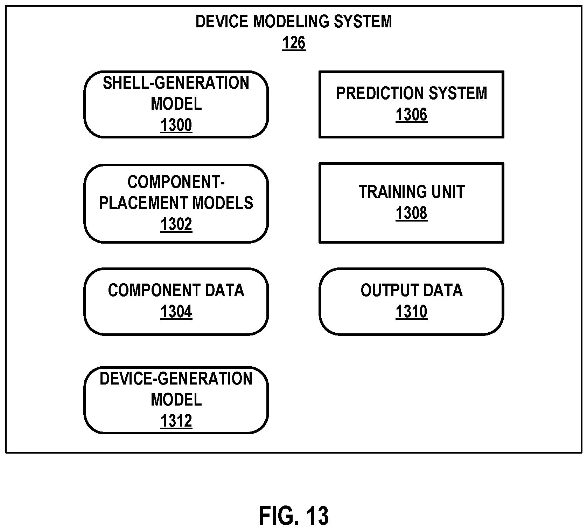

FIG. 13 is a block diagram illustrating an example device modeling system 126, in accordance with one or more techniques of this disclosure. In the example of FIG. 13, device modeling system 126 includes a shell-generation model 1300, component-placement models 1302, component data 1304, a prediction system 1306, a training unit 1308, output data 1310, and a device-generation model 1312. In some examples, such as examples where shell-generation model 1300 and component-placement models 1302 have already been trained, training unit 1308 is not included in device modeling system 126. In other examples, device modeling system 126 may include more, fewer, or different components. For instance, in some examples, device modeling system 126 includes device-generation model 1312 and not shell-generation model 1300, or component-placement models 1302. In some examples, device modeling system 126 does not include training unit 1308.

Shell-generation model 1300 includes a machine learning (ML) model that is trained to generate a 3D model of a shell of a patient-specific hearing instrument (i.e., a shell shape). Component-placement models 1302 may include ML models that are trained to predict positions and orientations of hardware components of the patient-specific hearing instrument. Example hardware components may include a receiver (i.e., a device for generating sound to be projected into the ear canal of the patient), electronics components, a wax guard, and so on. Component data 1304 may include data regarding sizes and types of components.

The electronics component may include processing circuitry, such as one or more microprocessors, digital signal processors, radios, charging circuitry, and so on. In some examples, the electronics component may also include a radio, data storage devices, and so on. The receiver may include one or more speakers configured to generate sound. The wax guard may include a screen and a screen support structure designed to prevent wax and other debris from entering the hearing instrument via a sound exit of the hearing instrument. The sound exit of the hearing instrument is a hole in the shell of the hearing instrument through which sound produced by the receiver passes on its way to the patient's ear drum.

Prediction system 1306 is configured to generate output data 1310. Output data 1310 may include a model of a hearing instrument based on ear modeling data 120. The hearing instrument may have a shell that is shaped specifically to fit an ear canal of the patient. Prediction system 1306 may apply shell-generation model 1300 to generate a shell shape for the hearing instrument based on ear modeling data 120. In addition, prediction system 1306 may apply component-placement models 1302 to generate a 3D arrangement of the components of the hearing instrument. Prediction system 1306 may refine the 3D arrangement of the components of the hearing instrument based on component data 1304. Prediction system 1306 may refine the shell shape based on the 3D arrangement of the components of the hearing instrument.

Thus, computing system 100 may obtain ear modeling data 120. Ear modeling data 120 includes a 3D model of an ear canal of a user (e.g., a patient). Computing system 100 may apply a shell-generation model to generate a shell shape based on the ear modeling data. The shell-generation model is a ML model and the shell shape is a 3D representation of a shell of a hearing instrument to be worn in the ear canal. Computing system 100 may apply a set of one or more component-placement models to determine, based on the ear modeling data, a position and orientation of a component of the hearing instrument. The component-placement models are independent of the shell-generation model and each of the component-placement models is a separate machine learning model. The computing system may generate, based on the position and orientation of the component and the shell shape, a hearing instrument model that is specific to the patient.

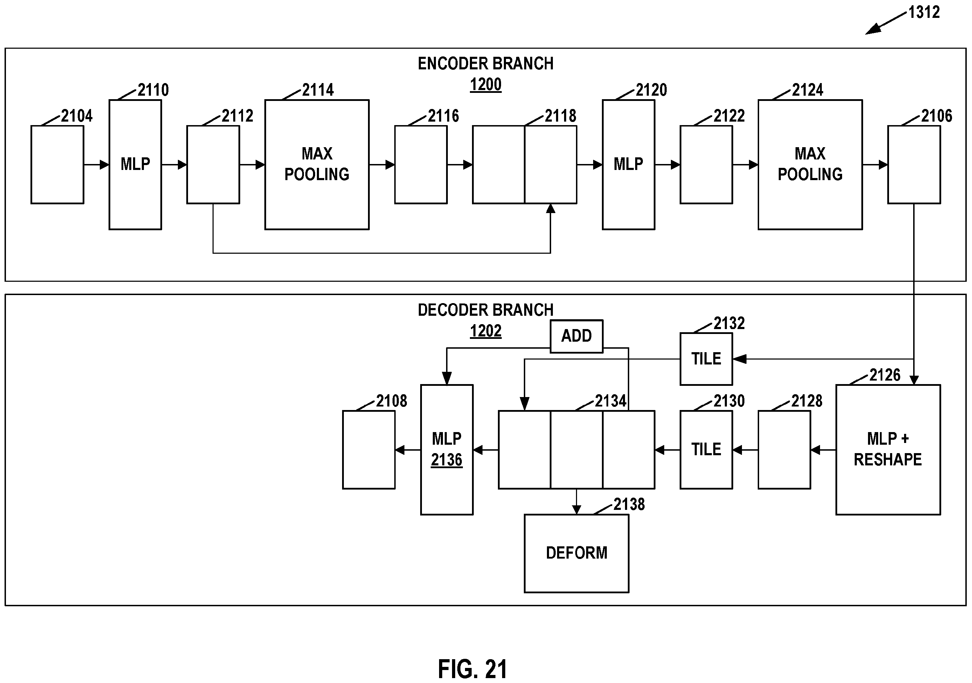

Device-generation model 1312 may be used instead of, or along with shell-generation model 1300 and component-placement models 1320. Prediction system 1306 may use device-generation model 1312 to predict a shell shape and component placements in a single trained ML model. In accordance with one or more techniques of this disclosure, device-generation model 1312 may have a point-cloud based neural network architecture. For instance, ear modeling data 120 may include a point cloud containing points on a surface of a patient's ear. Prediction system 1306 may provide this point cloud as input to device-generation model 1312 and may receive, as output, a point cloud containing points corresponding to a shell and components of a hearing instrument. An example point-cloud based neural network architecture is described below with respect to FIG. 21. It may be advantageous to use a point cloud in place of a 3D image because the point cloud may provide more accurate information about the surface of the ear than the 3D image, e.g., because of the 3D image inherently involves quantization of real points to voxels.

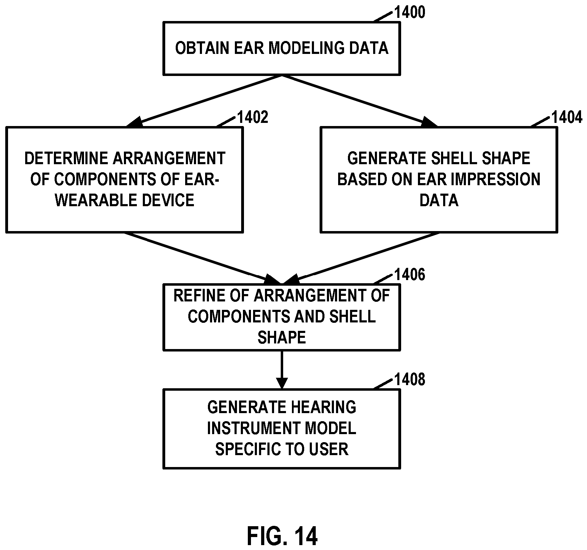

FIG. 14 is a flowchart illustrating an example process for generating a model of a patient-specific hearing instrument, in accordance with one or more techniques of the present disclosure. In the example of FIG. 14, computing system 100 may obtain ear modeling data 120 (1400). In some examples, computing system 100 obtains ear modeling data 120 from a device that scans an ear of a patient. In some examples, computing system 100 obtain ear modeling data 120 from a device that scans an ear impression formed by inserting a moldable material into the ear of the patient.

Prediction system 1306 may change the format of ear modeling data 120. For example, computing system 100 may obtain ear modeling data 120 in a mesh format and prediction system 1306 may change the format of ear modeling data 120 to a 3D image format. In the 3D image format, ear modeling data 120 includes a 3D array of voxels. Each voxel may indicate whether a corresponding location is open air or tissue of the patient. In some examples, prediction system 1306 may define a bounding box that contains a portion of ear modeling data 120 representing the patient's ear canal and excluding other, more lateral portions of the patient's ear, such as lateral portions of the patient's concha, the patient's tragus, antitragus, etc. Prediction system 1306 may convert the mesh data within the bounding box into voxels. In some examples, ear modeling data 120 is formatted as a point cloud. In some examples, prediction system 1306 may use ear modeling data 120 in the mesh format as input to machine learning models that determine an arrangement of the components and generate a shell shape.

In some examples, prediction system 1306 may change the orientation of ear modeling data 120. For instance, prediction system 1306 may change the orientation of ear modeling data 120 so that the ear canal is oriented along the z-dimension. In some examples, prediction system 1306 may scale, rotate, resample, or otherwise manipulate ear modeling data 120.

Prediction system 1306 may apply a set of one or more component-placement models 1302 to determine, based on ear modeling data 120, an arrangement of components of a patient-specific hearing instrument (1402). For instance, prediction system 1306 may determine spatial position and orientations (i.e., arrangement) of each of a plurality of components of the patient-specific hearing instrument. Such components may include an electronics unit, a receiver, a wax guard, sensor devices, microphones, and so on. As described in greater detail elsewhere in this disclosure, prediction system 1306 may apply one or more ML models, including component-placement models 1302, to generate the arrangement of the components of the patient-specific hearing instrument.

Furthermore, in the example of FIG. 14, prediction system 1306 may apply shell-generation model 1300 to generate a shell shape of the patient-specific hearing instrument based on ear modeling data 120 (1404). The shell shape is a shape of a shell of the patient-specific hearing instrument. The shell of the patient-specific hearing instrument is an object that defines an enclosure to contain the components of the patient-specific hearing instrument. The shell may have a shape configured to match the contours of an ear canal of the patient so that the patient-specific hearing instruments fits snugly within the ear canal of the patient. As described in greater detail elsewhere in this disclosure, prediction system 1306 may apply one or more ML models, including shell-generation model 1300, to generate the shell shape of the patient-specific hearing instrument.

As shown in the example of FIG. 14, prediction system 1306 may determine the arrangement of components of the patient-specific hearing instrument and generate the shell shape of the patient-specific hearing instrument independently. In some examples, prediction system 1306 may determine the arrangement of components of the patient-specific hearing instrument and generate the shell shape of the patient-specific hearing instrument in parallel.

In some examples, after determining the arrangement of the components and generating the shell shape, prediction system 1306 may refine the arrangement of the components and the shell shape (1406). For instance, as described in greater detail elsewhere in this disclosure, prediction system 1306 may change the shell shape based on the arrangement of the components.

Additionally, prediction system 1306 may output a hearing instrument model that is specific to the patient (1408). The hearing instrument model may represent the arrangement of the components and the shell shape. In some examples, prediction system 1306 may output the patient-specific hearing instrument model for display to the patient and/or a clinician. For instance, the clinician may show the patient-specific hearing instrument model to the patient during a consultation with the patient. In some examples, prediction system 1306 may transfer the patient-specific hearing instrument model to a coordinate space of ear modeling data 120. Thus, the patient-specific hearing instrument model may be displayed along with ear modeling data 120, e.g., to show the patient or clinician how the patient-specific hearing instrument would fit into the patient's ear canal.

In some examples, prediction system 1306 may output the model of the patient-specific hearing instrument to a manufacturing system 134 (FIG. 1). Manufacturing system 134 may manufacture the shell of the hearing instrument and a component support structure configured to retain the component at the determined position and orientation. For instance, manufacturing system 134 may manufacture a component support structure that is configured to hold the components of the patient-specific hearing instrument in the determined arrangement. Additionally, in some such examples, the components may be attached to the component support structure and immersed in a polymeric bath. A 3D printing apparatus of manufacturing system 134 may use a volumetric 3D printing process, such as holographic lithography or axial lithography to form a shell having the determined shell shape around the components. Additional details of this example manufacturing process are described in Patent Cooperation Treaty (PCT) publication WO 2021/096873, published May 20, 2021. In other examples, manufacturing system 134 may form the shell (e.g., using an additive manufacturing process or reductive manufacturing process) and a technician may insert the components into the shell.

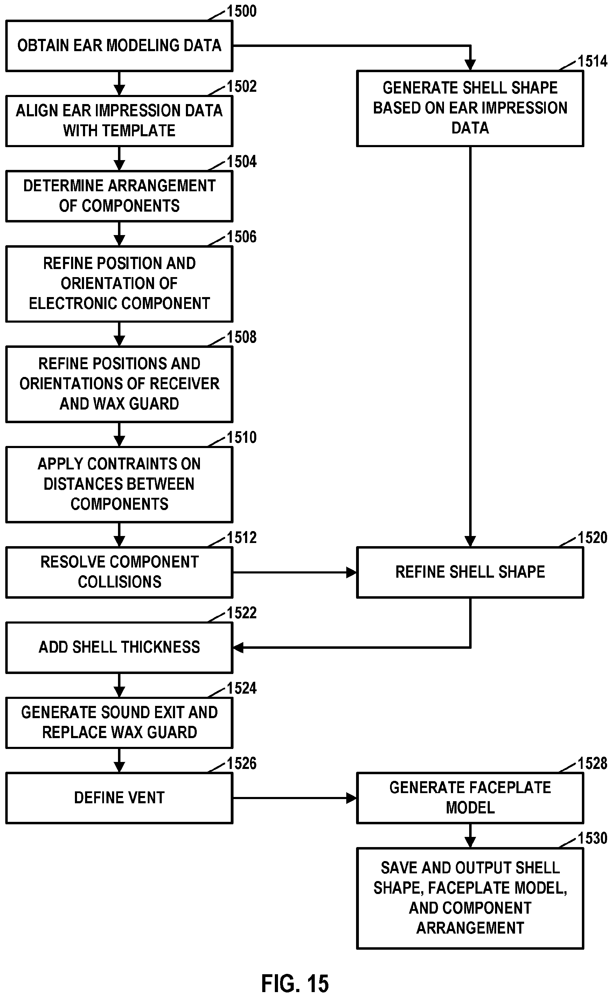

FIG. 15 is a flowchart illustrating an example process for generating a patient-specific hearing instrument model, in accordance with one or more techniques of the present disclosure. The example of FIG. 15 shows additional example details of the process of FIG. 14. In the example of FIG. 15, prediction system 1306 may obtain ear modeling data 120 (1500). Prediction system 1306 may obtain and manipulate ear modeling data 120 as described above with respect to FIG. 14.

In the example of FIG. 15, prediction system 1306 may align ear modeling data 120 with a template (1502). A template may be 3D model of an ear canal. The template is not specific to the patient. For instance, prediction system 1306 may perform a Nelder-Mead or Iterative Closest Point (ICP) method to determine a set of rotations that minimize differences in orientation and position between the ear modeling data 120 and the template. Aligning ear modeling data 120 with the template may help to reduce the influence of the orientation or position of ear modeling data on an estimated arrangement of the components.

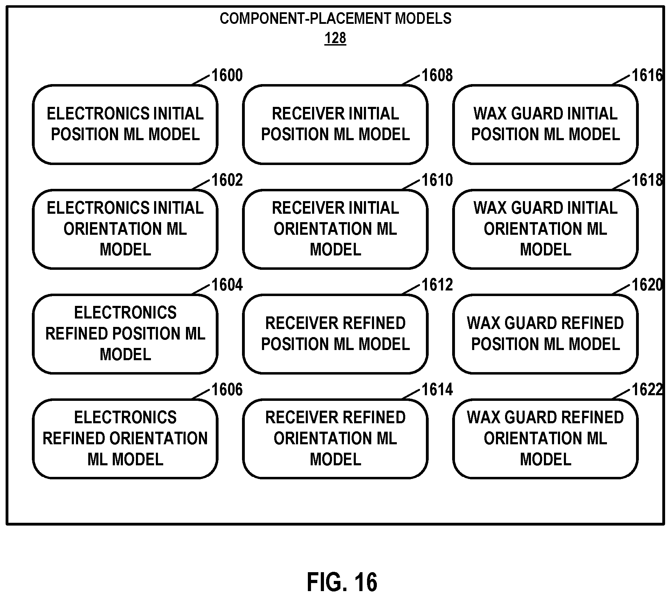

Furthermore, in the example of FIG. 15, prediction system 1306 may apply one or more of component-placement models 1302 to determine an arrangement of the components based on ear modeling data 120 (1504). The components may include an electronics component, a receiver, and a wax guard. In some examples, component-placement models 1302 may include a positioning ML model and an orientation ML model for each of the electronics component, the receiver, and the wax guard. Thus, in this example, component-placement models 1302 may include six ML models. Prediction system 1306 may apply the positioning ML model for a component to determine a 3D position of the component based on ear modeling data 120. Prediction system 1306 may apply the orientation ML model for a component to determine a 3D orientation of the component based on ear modeling data 120 and the determined 3D position of the component. FIG. 16, which is described in greater detail elsewhere in this disclosure, illustrates an example structure of a component-placement model. In some examples, the same structure may be used for positioning ML models and orientation ML models. In other examples, different structures may be used for positioning ML models and orientation ML models. In examples where an ML model is a neural network model, prediction system 1306 may apply the ML model by performing forward propagation of input data through the neural network model.

After estimating the arrangement of the components, prediction system 1306 may refine the position and orientation of the electronics component (1506). Additionally, prediction system 1306 may refine the positions and orientations of the receiver and wax guard (1508). In some examples, prediction system 1306 refines the positions and orientations of the receiver and wax guard after refining the position and orientation of the electronics component because the electronics component may affect the external appearance of the patient-specific hearing instrument. Prediction system 1306 may apply refinement ML models to refine the orientations and positions of each of the components.

Furthermore, prediction system 1306 may apply constraints on distances between the components (1510). For example, prediction system 1306 may check whether each of the components is at least a minimum distance another one of the components. In response to determining that the distance between two of the components is less than a minimum distance, prediction system 1306 may incrementally increase the distance between the components while maintaining the orientations of the components until the distance between the components is greater than or equal to the minimum distance. In some examples, prediction system 1306 may check whether a distance between two or more of the components exceeds a maximum distance. In response to determining that the distance between two of the components is greater than the maximum distance, prediction system 1306 may incrementally decrease the distance between the components while maintaining the orientations of the components until the distance between the components is less than or equal to the maximum distance.

In some examples, as part of applying the constraints on the distances between the components, prediction system 1306 may determine that there are collisions between two or more of the components or between any of the components and the skin of the ear canal as represented in ear modeling data 120. Accordingly, prediction system 1306 may resolve the component collisions (1512). For instance, in response to determining that there is a collision between two of the components, prediction system 1306 may incrementally increase the distance between the components while maintaining the orientations of the components until the distance between the components is greater than or equal to a minimum distance. In response to determining that there is a collision between a component and the skin of the ear canal, prediction system 1306 may incrementally increase the distance between the component and the skin of the ear canal until there is at least a minimum distance between the component and the skin of the ear canal. Prediction system 1306 may repeat the process of resolving collisions multiple times until there are no remaining collisions.

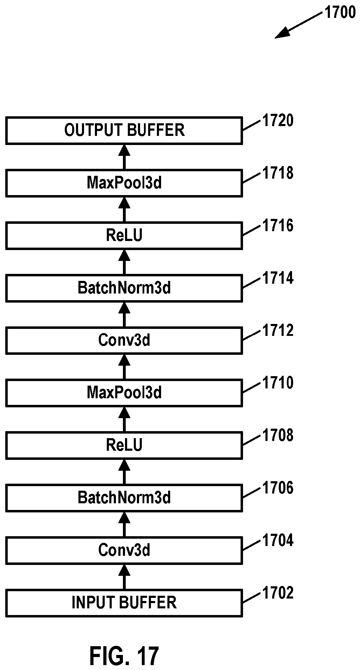

Additionally, in the example of FIG. 15, prediction system 1306 may generate a shell shape based on ear modeling data 120 (1514). For example, prediction system 1306 may apply shell-generation model 1300 to generate the shell shape based on ear modeling data 120. Shell-generation model 1300 may generate a 3D image of the shell shape. In some examples, after generating the 3D image of the shell shape, prediction system 1306 may convert the 3D image back into a mesh format. FIG. 17, which is described in greater detail elsewhere in this disclosure, illustrates an example structure of shell-generation model 1300.

After generating the shell shape, prediction system 1306 may refine the shell shape based on the arrangement of the components (1520). For example, prediction system 1306 may determine whether the arrangement of the components fits within the shell shape. In some instances, prediction system 1306 may determine whether the arrangement of the components fits within the shell shape by determining whether there are any collisions between the shell shape and the arrangement of the components. If the arrangement of the components does not fit within the shell shape, prediction system 1306 may increase a length of the shell shape into or out of the ear canal to accommodate the arrangement of components.

Additionally, prediction system 1306 may add shell thickness to the shell shape (1522). For instance, prediction system 1306 may modify voxels of the 3D image of the shell thickness so that the 3D image of the shell represents the shell having a minimum thickness. In some examples, to modify the voxels, prediction system 1306 may change a value of each respective voxel that is in a shell-wise interior direction from the existing shell shape and located within a given distance of a voxel in the existing shell shape to have a modified value indicating that the respective voxel is part of the shell shape.

Prediction system 1306 may generate a sound exit and replace the wax guard (1524). The wax guard may have a cylindrical shape. A medial rim of the wax guard (i.e., a rim of the wax guard that is oriented toward the medial plane of the patient) may be aligned with a medial surface of the shell shape. The medial surface of the shell shape may be a surface of the shell shape deepest in the patient's ear canal (e.g., a surface of the shell shape that is closest the medial plane of the patient). When generating the sound exit and replacing the wax guard, prediction system 1306 may modify the shell shape so that the shell shape defines a cylindrical cavity configured to accommodate the wax guard. In other words, prediction system 1306 may modify the shell shape to define a sound exit that accommodates the wax guard at the determined position and orientation of the wax guard. Sound generated by the receiver of the hearing instrument may exit the hearing instrument via a wax guard inserted into the cylindrical cavity. In other examples, the wax guard may have other shapes.

Additionally, prediction system 1306 may modify the shell shape to define a vent (1526). In other words, prediction system 1306 automatically define a vent in the shell of the hearing instrument. The vent may allow sound generated within the patient's head to escape outward. Absence of a vent may result in excessive soundwaves reflecting from the hearing instrument toward the patient's eardrum. In some examples, to define the vent, prediction system 1306 may identify locations on medial and lateral surfaces of the shell shape as openings of the vent. For instance, prediction system 1306 may prediction system 1306 may identify the superior-most locations on the medial and lateral surfaces as openings of the vent. Prediction system 1306 may then determine a path (e.g., a shortest path) along an inner surface of the shell shape from the identified locations on the medial and lateral surfaces of the shell shape that does not intersect any of the components.

Prediction system 1306 may generate a faceplate model for the hearing instrument (1528). The faceplate model is a model of a faceplate shaped to cover a lateral opening of the shell surface. Prediction system 1306 may generate the faceplate model based on the refined shell shape, as modified to include the vent. For instance, prediction system 1306 may determine a shape of the lateral opening and generate a faceplate model to have an outline matching the shape of the lateral opening with a notch or hole for the lateral opening of the vent.

After generating the faceplate model, prediction system 1306 may generate, based on positions and orientations of the components and the shell shape, a hearing instrument model that is specific to the patient (1532). Prediction system 1306 may generate the hearing instrument model as a combination of the shell shape, the faceplate model, and the positions and orientations of the components (i.e., the arrangement of the components). In some examples, the hearing instrument model may also include the faceplate model. Prediction system 1306 may save the shell shape, the faceplate model, and the component arrangement as output data 1310. In some examples, a display screen (e.g., one of output devices 110) displays the hearing instrument model.

FIG. 16 is a block diagram illustrating example component-placement models 1302, in accordance with one or more techniques of this disclosure. In the example of FIG. 16, component-placement models 1302 may include an electronics initial position ML model 1600, an electronics initial orientation ML model 1602, an electronics refined position ML model 1604, an electronics refined orientation ML model 1606, a receiver initial position ML model 1608, a receiver initial orientation ML model 1610, a receiver refined position ML model 1612, a receiver refined orientation ML model 1614, a wax guard initial position ML model 1616, a wax guard initial orientation ML model 1618, a wax guard refined position ML model 1620, and a wax guard refined orientation ML model 1622.

Prediction system 1306 may apply electronics initial position ML model 1600 to determine an initial position of an electronics component based on ear modeling data 120. Prediction system 1306 may apply electronics initial orientation ML model 1602 to determine an initial orientation of the electronics component based on ear modeling data 120 and, in some examples, the initial position of the electronics component. Prediction system 1306 may apply receiver initial position ML model 1608 to determine an initial position of a receiver based on ear modeling data 120. Prediction system 1306 may apply receiver initial orientation ML model 1610 to determine an initial orientation of the receiver based on ear modeling data 120 and, in some examples, the initial position of the receiver. Prediction system 1306 may apply wax guard initial position ML model 1616 to determine an initial position of a wax guard based on ear modeling data 120. Prediction system 1306 may apply wax guard initial orientation ML model 1618 to determine an initial orientation of the wax guard based on ear modeling data 120 and, in some examples, the initial position of the wax guard. Prediction system 1306 may apply electronics initial position ML model 1600, electronics initial orientation ML model 1602, receiver initial position ML model 1608, receiver initial orientation ML model 1610, wax guard initial position ML model 1616, and wax guard initial orientation ML model 1618 as part of step 1504 of FIG. 15 to estimate an arrangement of the components.

Furthermore, prediction system 1306 may apply electronics refined position ML model 1604 to determine a refined position of the electronics component based on ear modeling data 120 and the initial position of the electronics component. Prediction system 1306 may apply electronics refined orientation ML model 1606 to determine a refined orientation of the electronics component based on ear modeling data 120, the initial orientation of the electronics component, and component data 1304 for the electronics component. Prediction system 1306 may apply receiver refined position ML model 1612 to determine a refined position of the receiver based on ear modeling data 120, the initial position of the receiver, and component data 1304 for the receiver. Prediction system 1306 may apply receiver refined orientation ML model 1614 to determine a refined orientation of the receiver based on ear modeling data 120 and the initial orientation of the receiver. Prediction system 1306 may apply wax guard refined position ML model 1620 to determine a refined position of the wax guard based on ear modeling data 120 and the initial position of the wax guard. Prediction system 1306 may apply wax guard refined orientation ML model 1616 to determine a refined orientation of the wax guard based on ear modeling data 120, the initial orientation of the wax guard, and component data 1304 for the wax guard. Prediction system 1306 may apply electronics refined position ML model 1604 and electronics refined orientation ML model 1606 as part of step 306 of FIG. 3 to refine the position and orientation of the electronics component. Prediction system 1306 may apply receiver refined position ML model 1612, receiver refined orientation ML model 1614, wax guard refined position ML model 1620, and wax guard refined orientation ML model 1622 as part of step 308 of FIG. 15 to refine the positions and orientations of the receiver and wax guard.

Determining the initial positions and orientations of the components using a first set of ML models followed by refining the positions and orientations of the components using a second set of ML models may improve the quality arrangement of the components.

Thus, in the example of FIG. 16, as part of applying one or more component-placement models to determine a position and orientation of a first component, prediction system 1306 may apply a first component-placement model (e.g., electronics initial position ML model 1600, receiver initial position ML model 1608, or wax guard initial position ML model 1616) to generate, based on the ear modeling data, data indicating the position of the component. Prediction system 1306 may apply a second component-placement model (e.g., electronics initial orientation ML model 1602, receiver initial orientation ML model 1610, or wax guard initial orientation ML model 1618) to generate, based on the ear modeling data and the data indicating the position of the component, data indicating the orientation of the component. Furthermore, in some examples, the data indicating positions of the components may be preliminary data and prediction system 1306 may apply a component-placement model (e.g., electronics refined position ML model 1604, receiver refined position ML model 1612, or wax guard refined position ML model 1620) to determine, based on the ear modeling data and the preliminary data indicating the position of the component, refined data indicating the refined position of the component. Prediction system 1306 may apply a component-placement model (e.g., electronics refined orientation ML model 1606, receiver refined orientation ML model 1614, or wax guard refined orientation ML model 1622) to determine, based on the ear modeling data and the preliminary data indicating the orientation of the component, refined data indicating the orientation of the component.

In some examples, the inputs to one or more of electronics refined position ML model 1604, electronics refined orientation ML model 1606, receiver refined position ML model 1608, receiver refined orientation ML model 1610, wax guard refined position ML model 1620, and wax guard refined orientation ML model 1622 may include component data 1304. There may be several different available types of electronics components, receivers, and wax guards. The different types of these components may have somewhat different sizes and shapes. For example, if a patient has more profound hearing loss, a larger, more powerful receiver may be selected that is able to generate louder sounds. If the patient has less profound hearing loss, a smaller, less powerful receiver may be more appropriate. Similarly, electronics components with different capabilities may have somewhat different dimensions. Component data 1304 may indicate which component types were selected for the patient. Component data 1304 may indicate a selected component type in one or more ways. For instance, in some examples, component data 1304 may include dimensional data of a selected component type. In some examples, component data 1304 may include data indicating a model number of the selected component type. In some examples, instead of providing component data 1304 as input to refinement ML models (e.g., electronics refined position ML model 1604, electronics refined orientation ML model 1606, receiver refined position ML model 1608, receiver refined orientation ML model 1610, wax guard refined position ML model 1620, and wax guard refined orientation ML model 1622), there may be different refinement ML models for each component type.

FIG. 17 is a conceptual diagram illustrating an example structure of a component-placement model 1700, in accordance with one or more techniques of the present disclosure. Component-placement model 1700 may be any of the component-placement models shown in the example of FIG. 16. In the example of FIG. 17, component-placement model 1700 includes an input buffer 1702 that contains input for component-placement model 1700. For instance, input buffer 1702 may include a 3D image of ear modeling data 120. The 3D image of the ear modeling data provided as input to electronics refined position ML model 1604, electronics refined orientation ML model 1606, receiver refined position ML model 1612, receiver refined orientation ML model 1614, wax guard refined position ML model 1620, and wax guard refined orientation ML model 1622 may represent the ear canal of the patient and the corresponding component (e.g., electronics component, receiver, wax guard) at the initial positions and orientations determined by ML models 1600, 1602, 1608, 1610, 1616, and 1618. In some examples, input buffer 1702 may include a 3D matrix of size 44x44x44 to store the 3D image of ear modeling data 120. The 3D matrix of size 44x44x44 may represent a 22-millimeter (mm) x 22mm x 22mm bounding box. Data in input buffer 1702 may be normalized to a 0 to 1 range.

A first convolutional layer 1704 may apply a 3D convolution over data in input buffer 1702. A first batch normalization layer 1706 may apply batch normalization to the output of convolutional layer 1704. A first Rectified Linear Unit (ReLU) layer 1708 applies a ReLU activation function to output of batch normalization layer 1706. A first max pooling layer 1710 applies a 3D max pooling process to the output of ReLU layer 1708. A second convolutional layer 1712 applies a 3D convolution to the output of max pooling layer 1710. A second batch normalization layer 1714 may apply batch normalization to the output of second convolutional layer 1712. A second ReLU layer 1716 may apply the ReLU activation function to output of second batch normalization layer 1714. A second max pooling layer 1718 may apply the 3D max pooling process to the output of second ReLU layer 1716. In other examples, activation functions other than the ReLU activation function may be used. Moreover, in some examples, different activation functions may be used in component-placement models for determining positions of components and in component-placement models for determining orientations of components. For instance, the ReLU activation function may be used in component-placement models for determining positions of components and a sigmoid activation function may be used in component-placement models for determining orientations of components.

An output buffer 1720 may store the output of second max pooling layer 1718. In instances where component-placement model 7100 determines a position of a component, the output stored in output buffer 1720 may include coordinate values indicating position in 3D space of the component. For instance, the output stored in output buffer 1720 may include an x-coordinate, a y-coordinate, and a z-coordinate. In some examples, the coordinates correspond to a centroid of the component. In other examples, the coordinates may correspond to a landmark point on the component, such as a comer of the component. In instances where component-placement model 1700 determines an orientation of a component, the output stored in output buffer 1720 may include values that indicate an orientation of the component in the 3D space. For instance, the output stored in output buffer 1720 may include angle values. In other instances, output stored in output buffer 1720 may include a set of coordinates of a second point. A line from a point indicated by the coordinates determined for the position of the component and the second point corresponds to the orientation of the component.

Training unit 1308 may train component-placement model 1700. Training unit 1308 may train component-placement model 1700 based on training data. The training data may be based on records of arrangements of components in manually designed hearing instruments. For example, the training data may include input-output pairs. The input of an input-output pair may include ear modeling data 120. The input of an input-output may also include other information, such as a preliminary data indicating a position of a component, preliminary data indicating an orientation of a component, refined data indicating a position of a component, data indicating a component type, and so on. The output of an input-output pair may include data indicating a position or an orientation of a component. Training unit 1308 may perform a forward propagation pass through component-placement model 1700 using the input of an input-output pair. Training unit 1308 may apply a loss function that generates a loss value based on the resulting output of component-placement model 1700 and the output of the input-output pair. In some examples where component-placement model 1700 determines a position of a component, the loss function calculates the loss value as a mean squared error of the differences between the position determined by component-placement model 1700 and a position indicated by the output of the input-output pair. In some examples where component-placement model 1700 determines an orientation of a component, the loss function calculates the loss value as a sum of differences between angles determined by component-placement model 1700 and angles indicated by the output of the input-output pair.

Training unit 1308 may use the loss value in a backpropagation process that may update weights and other parameters of component-placement model 1700. During the backpropagation process, training unit 1308 may use an Adam optimizer to perform stochastic gradient descent. Training unit 1308 may use a learning rate of 0.001.

In some examples, training unit 1308 may train component-placement model 1700 using training data in which the input of the input-output pairs is based on ear impressions formed by inserting a moldable material into ears of patients. Later training data may input-output pairs in which the input is based on optical scans of ears of patients. Rather than fully retrain component-placement model 1700 using this later training data, training unit 1308 may fix the weights of one or more layers of component-placement model 1700 and only continue to modify weights of the last layer (e.g., layer 512) of component-placement model 1700. This may be an example of transfer learning.

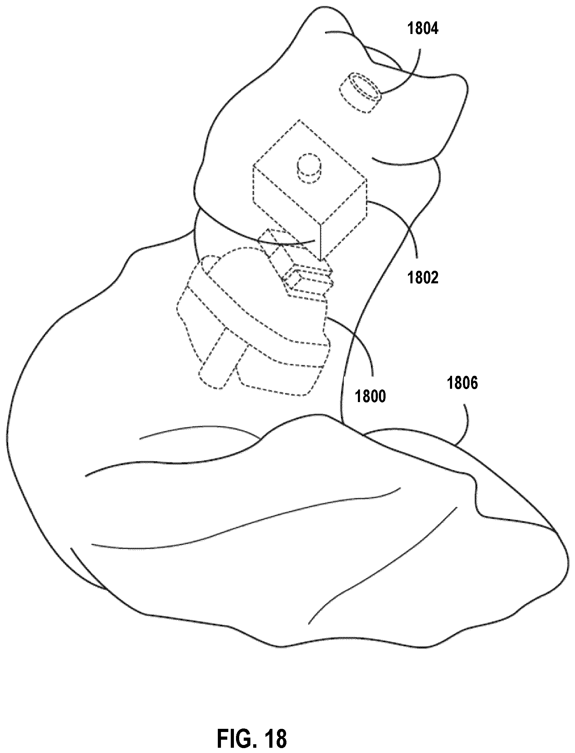

FIG. 18 is a conceptual diagram illustrating an example arrangement of components of a hearing instrument, in accordance with one or more techniques of the present disclosure. In the example of FIG. 18, an electronics component 1800, a receiver 1802, and a wax guard 1804 are arranged within a shell 1806. The shape of shell 1806 may be patient specific. In some examples, computing system 100 generates data to cause manufacturing system 134 to manufacture a patient-specific component that retains the components in the arrangement. In some examples, computing system 100 generates data to cause manufacturing system 134 to manufacture a patient-specific shell 1806.

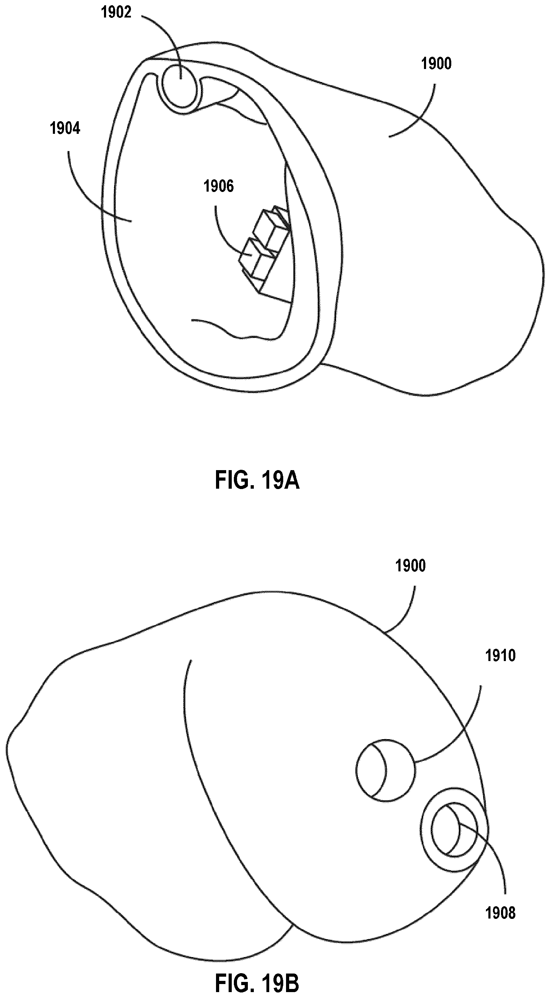

FIG. 19A and FIG. 19B are conceptual diagrams illustrating example vent placement, in accordance with one or more techniques of the present disclosure. FIG. 19A shows a shell 1900 from a direction looking toward the medial plane of the patient. FIG. 19B shows shell 1900 from a direction looking away from the medial plane of the patient. As shown in FIG. 19A, shell 1900 defines a lateral vent opening 1902. An interval cavity 1904 defined by shell 1900 includes components, such as an electronics component 706. As shown in FIG. 19B, shell 1900 defines a sound exit 1908 and a medial vent opening 1910. A wax guard may be inserted into sound exit 1908.

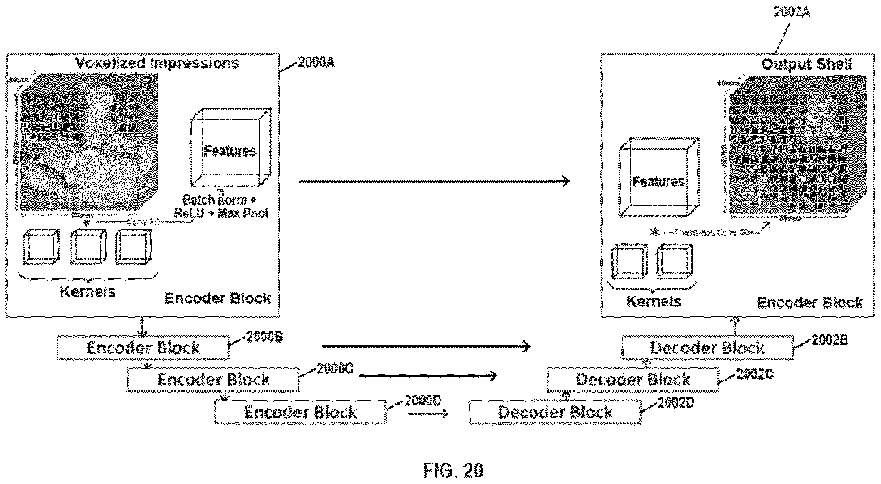

FIG. 20 is a conceptual diagram illustrating an example structure of shell-generation model 1300, in accordance with one or more techniques of the presenting disclosure. In the example of FIG. 20, shell-generation model 1300 has a U-net architecture. More specifically, shell-generation model 1300 includes a set of encoder blocks 2000A-2000D (collectively, "encoder blocks 2000") and a set of decoder blocks 2002A-2002E (collectively, "decoder blocks 2002"). Encoder block 2000A receives ear modeling data 120 as a 3D image (i.e., a voxelized impression). In the example of FIG. 20, the 3D image represents a cube with 80 millimeters (mm) on each side. The output of encoder block 2000A is a 3D feature array. Input to encoder block 2000B may include the 3D feature array generated by encoder block 2000A. Input to encoder block 2000C may include a 3D feature array generated by encoder block 2000B. Input to encoder block 2000D may include a 3D feature array generated by encoder block 2000C.

Encoder block 2000A includes a set of one or more convolutional kernels. In the example of FIG. 20, encoder block 2000A includes 3 convolutional kernels. In some examples, each of the convolutional kernels has a 1x1 convolution of stride length 2. Each of the convolutional kernels may be followed by a batch normalization (batch norm) layer, an activation layer (e.g., a ReLU activation layer), and a max pooling layer. Each of encoder blocks 2000B, 2000C, and 2000D may have a similar structure of convolutional kernels and layers to encoder block 2000A.

Input to decoder block 2002D may be a 3D feature array generated by encoder block 2000D. Input to decoder block 2002C may include a 3D feature array generated by decoder block 2002D concatenated with the 3D feature array generated by encoder block 2000C. Input to decoder block 2002B may include a 3D feature array generated by decoder block 2002C concatenated with the 3D feature array generated by encoder block 2000B. Input to decoder block 2002A may include a 3D feature block generated by decoder block 2002B concatenated with the 3D feature block generated by encoder block 2000A.

Decoder block 2002A includes a set of transpose convolutional kernels. In the example of FIG. 20, decoder block 2002A includes 2 transpose convolutional kernels. In some examples, each of the transpose convolutional kernels is a 1x1 up-convolution of stride length 2. Decoder block 2002A may generate a 3D image of a shell shape (i.e., an output shell). Each of decoder blocks 2002B, 2002C, and 2002D may have a similar structure to decoder block 2002D with the exception that decoder blocks 2002B, 2002C, and 2002D generate 3D feature arrays.

Training unit 1308 may train shell-generation model 1300. Training unit 1308 may train component-placement models 1302 separately from shell-generation model 1300. As part of training shell-generation model 1300, training unit 1308 may obtain training data. The training data may include input-output pairs. For each of the input-output pairs, the input data may include a 3D image of an ear canal. The output of an input-output pair may include a shell shape. The shell shape may be a 3D image of a shell. In some examples, the shell shape may include a retention feature. In some examples, training unit 1308 obtains the training data from a database that contains patient records that include ear modeling data of the patients and shell shapes designed by human professionals.

Training unit 1308 may perform forward propagation through shell-generation model 1300 to generate a shell shape based on the ear modeling data of an input of an input-output pair. Training unit 1308 may then apply a loss function that generates a loss value based on the generated shell shape and the shell shape of the output of the input-output pair. Training unit 1308 may use the loss value in a backpropagation process that updates weights within shell-generation model 1300. In some examples, training unit 1308 may determine the loss value used in the backpropagation process based on loss values generated by the loss function for multiple input-output pairs.

In some examples, the loss function may be intersection over union. In other words, training unit 1308 may calculate a 3D area of the intersection between the generated shell shape and the shell shape of the output of the input-output pair. Additionally, training unit 1308 may calculate a 3D area of the union of the generated shell shape and the shell shape of the output of the input-output pair. The union of these two shell shapes is the total area enclosed by the two shell shapes without double counting the intersection of the two shell shapes. Training unit 1308 may calculate the loss value by dividing the intersection by the union. The loss value approaches 1 as generated shell shapes come to more closely match shell shapes in outputs of input-output pairs. The loss value approaches 0 for dissimilar shell shapes. During the backpropagation process, training unit 1308 may perform gradient ascend to adjust the weights. In some examples, training unit 1308 may use an Adam optimizer to adjust the weights during the backpropagation process. A learning rate of the Adam optimizer may be 0.001 or another value.

As previously mentioned, prediction system 1306 may use device-generation model 1312 to generate a device model that includes a shell and one or more components. FIG. 21 is a block diagram illustrating an example implementation of device-generation model 1312, in accordance with one or more techniques of this disclosure. Device-generation model 1312 may be based on the architecture described in Yuan et al., "PCN: Point Completion Network", arXiv:1808.00671v3 [cs.CV] 26 Sep 2019.

In the example of FIG. 21, aperture prediction model 802 includes an encoder branch 2100 and a decoder branch 2102. Encoder branch 2100 accepts an ear impression point cloud 2104 as input. Ear impression point cloud 2104 may include points representing locations on a surface of the patient's ear, e.g., including points on the surface of the patient's outer ear and points on the surface of the patient's ear canal. Encoder branch 2100 generates a feature vector 2106 that serves as input to decoder branch 2102. Advantageously, the type of neural network shown in FIG. 21 may impart permutation invariance and noise tolerance properties to ear impression point cloud 2104. Because of the permutation invariance property, an initial orientation and scale of ear impression point cloud 2104 does not affect the output of the neural network.

Decoder branch 2102 outputs a device model point cloud 2108. Device model point cloud 2108 may include a collection of points on the surfaces of the shell, faceplate, retention member, and/or components of a hearing instrument.

As shown in the example of FIG. 21, encoder branch 2100 may include a first shared multi-layer perceptron (MLP) 2110 that receives ear impression point cloud 2104 as input and outputs a feature vector 2112. A point-wise max pooling layer 2114 is then applied to feature vector 2112 to generate a global feature vector 2116. Global feature vector 2116 is concatenated with feature vector 2112 to form a feature vector 2118. A second shared MLP 2120 is applied to feature vector 2118 to form a point feature vector 2122. Another point-wise max pooling layer 2124 is applied to point feature vector 2122 to form feature vector 2106. MLP 2110 may include two linear layers with ReLU activation. For each of shared MLP 2110 and shared MLP 2120, the first layer may apply a transform, e.g., using a T-Net neural network and then multiplying the input point cloud or feature vector by the output of the T-Net neural network, e.g., as described in Qi et. al., "PointNet: Deep Learning on Point Sets for 3D Classification and Segmentation," arXiv:1612.00593v2 [cs.CV] 10 Apr 2017.

Decoder branch 2102 applies a MLP 1226 and reshapes the output of MLP 2126 to generate a coarse ear aperture point cloud 2128. MLP 2126 may be a fully connected network with 3s output units and decoder branch 2102 may reshape the output of MLP 2126 to an *s* x 3 matrix, where s is a number of patches. Decoder branch 2102 may perform a folding operation that takes a point q*ᵢ* in the coarse output Y_{coarse} (coarse ear aperture point cloud 2128 and the k-dimensional global feature v (feature vector 1206_ as inputs, and generates a patch of t = u² points in local coordinates centered at qᵢ by deforming a u x u grid. Decoder branch 2102 takes points on a zero-centered u x u grid with side length *r,* where *r* controls the scale of the output patch, and organizes the coordinates into a *t* x 2 matrix G. Then, decoder branch 2102 concatenates each row of G with the coordinates of the center point qi and the global feature vector v, and passes the resulting matrix 1234 through a shared MLP 2136 that generates a *t* x 3 matrix Q, i.e., the local patch centered at qᵢ. Shared MLP 2136 can be interpreted as a nonlinear transformation that deforms the 2D grid into a smooth 2D manifold in 3D space. The same MLP is used in the local patch generation for each q; so the number of parameters in the local folding operation does not grow with the output size.

In some examples, aperture prediction model 802 (FIG. 8) may be implemented in a similar way to device-generation model 1312, except that the output point cloud contains points in the patient's ear aperture plane.

The following is a non-limiting list of clauses in accordance with one or more techniques of this disclosure.

Clause 1A. A method comprising: obtaining, by one or more processors implemented in circuitry, ear modeling data representing a 3-dimensional (3D) impression of an ear surface of an ear of a patient; and determining, by the one or more processors, based on the ear modeling data, values of one or more landmarks of the ear, wherein determining the values of the one or more landmarks comprises: predicting, by the one or more processors, an ear aperture plane of the ear; determining, by the one or more processors, a plurality of cross-sectional planes that are aligned with the ear aperture plane; for each of the cross-sectional planes: determining, by the one or more processors, an intersection boundary of the cross-sectional plane representing a line of intersection between the cross-sectional plane and the ear; and determining, by the one or more processors, a centroid of the intersection boundary of the cross-sectional plane; and determining, by the one or more processors, values of the one or more landmarks based on the centroids.

Clause 2A. The method of clause 1A, wherein predicting the ear aperture plane comprises applying, by the one or more processors, a trained machine learning (ML) model to the ear modeling data to determine an ear aperture plane of an aperture of an ear canal of the ear of the patient.

Clause 3A. The method of any of clauses 1A-2A, wherein predicting the ear aperture plane comprises: aligning, by the one or more processors, each of a plurality of ear shape templates with the ear modeling data, wherein each of the ear shape templates has a predefined ear aperture plane; determining, by the one or more processors, a difference or similarity metric for the aligned ear shape templates; selecting, by the one or more processors, an ear shape template from the plurality of ear shape templates based on the difference or similarity metric; and predicting, by the one or more processors, the ear aperture plane based on the predefined ear aperture plane of the selected ear shape template.

Clause 4A. The method of any of clauses 1A-3A, wherein the landmarks include one or more ear canal landmarks.

Clause 5A. The method of clause 4A, wherein the ear canal landmarks include of: a location of a first bend of the ear canal, a location of a second bend of the ear canal, an angle of the first bend of the ear canal, an angle of the second bend of the ear canal, a center line of the ear canal, a length of the ear canal, or a width of the ear canal.

Clause 6A. The method of any of clauses 1A-5A, wherein the landmarks further include one or more outer ear landmarks and determining the one or more landmarks further comprising determining, based on the ear modeling data, values of the one or more outer ear landmarks of the ear of the patient.

Clause 7A. The method of clause 6A, wherein the one or more outer ear landmarks include a position of a helix of the ear, a position of a tragus of the ear, or a volume of a concha of the ear.

Clause 8A. The method of any of clauses 1A-7A, further comprising: determining, by the one or more processors, based on the values of the one or more landmarks, whether one or more hearing instrument types are suitable for the patient; and outputting, by the one or more processors, one or more indications of whether the one or more hearing instrument types are suitable for the patient.

Clause 9A. The method of any of clauses 2A-8A, wherein: the ear modeling data comprises a first point cloud representing the ear surface, applying the trained ML model comprises: providing the first point cloud as input to the trained ML model; and obtaining a second point cloud representing the ear aperture plane as output of the trained ML model.

Clause 10A. The method of any of clauses 1A-9A, further comprising calculating statistical data regarding ears of a population of patients based in part on the values of the landmarks.

Clause 11A. The method of clause 10A, further comprising determining, by the one or more processors, based on the statistical data, a relationship between observed values of the landmarks in the population and returns of hearing instruments provided to the patients in the population.

Clause 12A. The method of any of clauses 10A-11A, further comprising generating, by the one or more processors, based on the statistical data and the values of landmarks, a recommendation regarding whether a specific type of hearing instrument is suitable for the patient.

Clause 13A. The method of any of clauses 1A-12A, wherein the values of the landmarks are first values of the landmarks, the ear modeling data is first ear modeling data, the first ear modeling data represents the 3D impression of the ear surface while a jaw of the patient is open, and the method further comprises: obtaining, by the one or more processors, second ear modeling data representing a 3D impression of the ear surface the jaw of the patient is closed; and determining, by the one or more processors, based on the second ear modeling data, second values of the landmarks.

Clause 14A. The method of clause 13A, further comprising determining, by the one or more processors, a shape of a shell of a hearing instrument based at least in part on the first values of the landmarks and the second values of the landmarks.

Clause 15A. The method of any of clauses 13A-14A, further comprising calculating, by the one or more processors, statistical data regarding ears of a population of patients based in part on the first values of the landmarks and the second values of the landmarks.

Clause 16A. The method of clause 15A, the method further comprises at least one of: determining, by the one or more processors, based on the statistical data, a correlation between observed values of the landmarks in the population and returns of hearing instruments provided to the patients in the population, or generating, by the one or more processors, based on the statistical data, the first values of landmarks, and the second values of the landmarks, a recommendation regarding whether a specific type of hearing instrument is suitable for the patient.

Clause 17A. The method of any of clauses 15A-16A, the method further comprises at least one of: determining, by the one or more processors, based on the statistical data, a correlation between observed values of the landmarks in the population and returns of hearing instruments having specific feature sets provided to the patients in the population, or generating, by the one or more processors, based on the statistical data, the first values of landmarks, and the second values of the landmarks, a recommendation regarding whether a specific feature set is suitable for the patient.

Clause 18A. The method of any of clauses 1A-17A, further comprising: determining, by the one or more processors, based on the values of the landmarks, whether the ear modeling data is adequate to generate a device model of a hearing instrument; based on the ear modeling data being adequate to generate the device model, generating the device model based on the ear modeling data; and manufacturing the hearing instrument based on the device model.

Clause 19A. A computing system comprising: a memory configured to store ear modeling data representing a 3-dimensional (3D) impression of an ear surface of an ear of a patient; and one or more processors implemented in circuitry, the one or more processors configured to perform the methods of any one of clauses 1A-18A.

Clause 20A. A system comprising: one or more storage devices configured to store ear modeling data, wherein the ear modeling data includes a 3D model of an ear canal of a patient; one or more processors implemented in circuitry, the one or more processors configured to perform the methods of any of clauses 1A-18A.

Clause 21A. A non-transitory computer-readable storage medium having instructions stored thereon that, when executed, cause a computing system to perform the methods of any of clauses 1A-18A.

Clause 1B. A method comprising: obtaining, by one or more processors of a computing system, ear modeling data representing an impression of an ear of a patient; generating, by the one or more processors, based on the ear modeling data, a shell model and one or more component models, the shell model being a model of a shell of a hearing instrument, the component models being models of internal components of the hearing instrument; and determining, by the one or more processors, based on the shell model and the one or more component models, whether there are one or more collisions between the shell model and the one or more component models.

Clause 2B. The method of clause 1B, wherein: the shell model comprises a first mesh and the one or more component models comprise one or more second meshes, and determining whether there are collisions between the shell model and the one or more components models comprises determining, by the one or more processors, whether any point of any of the one or more second meshes is located outside the first mesh.

Clause 1C. A method comprising: obtaining, by one or more processors implemented in circuitry, ear modeling data representing an impression of an ear of a patient; determining, by the one or more processors, based on the ear modeling data, whether the ear modeling data is adequate to generate a device model of a hearing instrument; and outputting, by the one or more processors, an indication of whether the ear modeling data is adequate to generate the device model of the hearing instrument.

Clause 2C. The method of clause 1C, wherein determining whether the ear modeling data is adequate to generate the device model comprises: determining, by the one or more processors, based on the ear modeling data, values of one or more landmarks of the ear; and determining, by the one or more processors, based on the values of the one or more landmarks being statistical outliers, that the ear modeling data is not adequate to generate the device model.

Clause 3C. The method of any of clauses 1C-2C, wherein determining whether the ear modeling data is adequate to generate the device model comprises: determining, by the one or more processors, based on the ear modeling data, which of a left or right ear the ear modeling data represents; and determining, by the one or more processors, that the ear modeling data is not adequate to generate the device model if the device model is being design for an opposite ear of whichever of the left or right ear the ear modeling data represents.

Clause 4C. The method of any of clauses 1C-3C, wherein determining whether the ear modeling data is adequate to generate the device model comprises: aligning, by the one or more processors, the ear modeling data with a plurality of ear shape templates; determining, by the one or more processors, difference or similarity metrics for the ear shape templates, the difference or similarity metrics indicating being measures of differences or similarities of the ear shape templates and the ear modeling data; and determining, by the one or more processors, whether the ear modeling data is adequate to generate the device model based on the difference or similarity metrics for the ear shape templates.

Clause 1D. A method comprising: obtaining, by one or more processors of a computing system, ear modeling data representing an impression of an ear of a patient; determining, by the one or more processors, whether a specific type of hearing instrument is feasible given a shape of the ear of the patient; and outputting, by the one or more processors, an indication of whether the specific type of hearing instrument is feasible given the shape of the ear of the patient.

Clause 2D. The method of clause 1D, wherein the specific type of hearing instrument is one of an Invisible in the Canal (IIC) hearing instrument, a Completely in the Canal (CIC), an In the Canal (ITC) hearing instrument, or an In the Ear (ITE) hearing instrument.

Clause 3D. The method of any of clauses 1D-2D, further comprising: determining, by the one or more processors, values of landmarks of the ear, wherein determining whether the specific type of hearing instrument is feasible comprises determining, by the one or more processors, based on the values of the landmarks of the ear where the specific type of hearing instrument is feasible given the shape of the ear of the patient.

Clause 1E. A method comprising: obtaining, by one or more processors of a computing system, ear modeling data representing an impression of an ear of a patient; determining, by the one or more processors, whether to recommend a hearing instrument include a retention feature given a shape of the ear of the patient; and based on a determination to recommend the hearing instrument include the retention feature, outputting, by the one or more processors, a recommendation that the hearing instrument include the retention feature.

Clause 2E. The method of clause 1E, wherein the recommendation includes a recommendation for a specific type of retention feature.

Clause 3E. The method of any of clauses 1E-2E, further comprising generating, by the one or more processors, a device model for a custom hearing instrument that includes the retention feature.

Clause 4E. The method of clause 3E, further comprising manufacturing the custom hearing instrument based on the device model for the custom hearing instrument.

Clause 1F. A method comprising a combination of any of clauses 1A-4E.

Clause 1G. A computing system comprising: a memory configured to store ear modeling data representing a 3-dimensional (3D) impression of an ear surface of an ear of a patient; and one or more processors implemented in circuitry, the one or more processors configured to perform the methods of any one of clauses 1A-1F.

Clause 2G. A system comprising: one or more storage devices configured to store ear modeling data, wherein the ear modeling data includes a 3D model of an ear canal of a patient; and one or more processors implemented in circuitry, the one or more processors configured to perform the methods of any of clauses 1A-1F.

Clause 3G. A non-transitory computer-readable storage medium having instructions stored thereon that, when executed, cause a computing system to perform the methods of any of clauses 1A-1F.

Clause 1. A method comprising:
obtaining, by one or more processors implemented in circuitry, ear modeling data representing a 3-dimensional (3D) impression of an ear surface of an ear of a patient; and
determining, by the one or more processors, based on the ear modeling data, values of one or more landmarks of the ear, wherein determining the values of the one or more landmarks comprises:
   predicting, by the one or more processors, an ear aperture plane of the ear;
   determining, by the one or more processors, a plurality of cross-sectional planes that are aligned with the ear aperture plane;
   for each of the cross-sectional planes:
      determining, by the one or more processors, an intersection boundary of the cross-sectional plane representing a line of intersection between the cross-sectional plane and the ear; and
      determining, by the one or more processors, a centroid of the intersection boundary of the cross-sectional plane; and
      determining, by the one or more processors, the values of the one or more landmarks based on the centroids.

Clause 2. The method of clause 1, wherein predicting the ear aperture plane comprises applying, by the one or more processors, a trained machine learning (ML) model to the ear modeling data to predict the ear aperture plane.

Clause 3. The method of clause 2, wherein:
the ear modeling data comprises a first point cloud representing the ear surface,
applying the trained ML model comprises:
   providing the first point cloud as input to the trained ML model; and
   obtaining a second point cloud representing the ear aperture plane as output of the trained ML model.

Clause 4. The method of clause 1, wherein predicting the ear aperture plane comprises:
aligning, by the one or more processors, each of a plurality of ear shape templates with the ear modeling data, wherein each of the ear shape templates has a predefined ear aperture plane;
determining, by the one or more processors, a difference or similarity metric for the aligned ear shape templates;
selecting, by the one or more processors, an ear shape template from the plurality of ear shape templates based on the difference or similarity metric; and
predicting, by the one or more processors, the ear aperture plane based on the predefined ear aperture plane of the selected ear shape template.

Clause 5. The method of clause 1, wherein the landmarks include one or more ear canal landmarks.

Clause 6. The method of clause 5, wherein the ear canal landmarks include of: a location of a first bend of the ear canal, a location of a second bend of the ear canal, an angle of the first bend of the ear canal, an angle of the second bend of the ear canal, a center line of the ear canal, a length of the ear canal, or a width of the ear canal.

Clause 7. The method of clause 1, wherein the landmarks further include one or more outer ear landmarks and determining the one or more landmarks further comprising determining, based on the ear modeling data, values of the one or more outer ear landmarks of the ear of the patient.

Clause 8. The method of clause 7, wherein the one or more outer ear landmarks include a position of a helix of the ear, a position of a tragus of the ear, or a volume of a concha of the ear.

Clause 9. The method of clause 1, further comprising:
determining, by the one or more processors, based on the values of the one or more landmarks, whether one or more hearing instrument types are suitable for the patient; and
outputting, by the one or more processors, one or more indications of whether the one or more hearing instrument types are suitable for the patient.

Clause 10. The method of clause 1, further comprising calculating statistical data regarding ears of a population of patients based in part on the values of the landmarks.

Clause 11. The method of clause 10, further comprising determining, by the one or more processors, based on the statistical data, a relationship between observed values of the landmarks in the population and returns of hearing instruments provided to the patients in the population.

Clause 12. The method of clause 10, further comprising generating, by the one or more processors, based on the statistical data and the values of the one or more landmarks, a recommendation regarding whether a specific type of hearing instrument is suitable for the patient.

Clause 13. The method of clause 1, wherein the values of the landmarks are first values of the landmarks, the ear modeling data is first ear modeling data, the first ear modeling data represents the 3D impression of the ear surface while a jaw of the patient is open, and the method further comprises:
obtaining, by the one or more processors, second ear modeling data representing a 3D impression of the ear surface the jaw of the patient is closed; and
determining, by the one or more processors, based on the second ear modeling data, second values of the landmarks.

Clause 14. The method of clause 13, further comprising determining, by the one or more processors, a shape of a shell of a hearing instrument based at least in part on the first values of the landmarks and the second values of the landmarks.

Clause 15. The method of clause 13, further comprising calculating, by the one or more processors, statistical data regarding ears of a population of patients based in part on the first values of the landmarks and the second values of the landmarks.

Clause 16. The method of clause 15, the method further comprises at least one of:
determining, by the one or more processors, based on the statistical data, a correlation between observed values of the landmarks in the population and returns of hearing instruments provided to the patients in the population, or
generating, by the one or more processors, based on the statistical data, the first values of landmarks, and the second values of the landmarks, a recommendation regarding whether a specific type of hearing instrument is suitable for the patient.

Clause 17. The method of clause 15, the method further comprises at least one of:
determining, by the one or more processors, based on the statistical data, a correlation between observed values of the landmarks in the population and returns of hearing instruments having specific feature sets provided to the patients in the population, or
generating, by the one or more processors, based on the statistical data, the first values of landmarks, and the second values of the landmarks, a recommendation regarding whether a specific feature set is suitable for the patient.

Clause 18. The method of clause 1, further comprising:
determining, by the one or more processors, based on the values of the landmarks, whether the ear modeling data is adequate to generate a device model of a hearing instrument;
based on the ear modeling data being adequate to generate the device model, generating the device model based on the ear modeling data; and
manufacturing the hearing instrument based on the device model.

Clause 19. A computing system comprising:
one or more memories configured to store ear modeling data representing a 3-dimensional (3D) impression of an ear surface of an ear of a patient; and
one or more processors implemented in circuitry, the one or more processors configured to determine, based on the ear modeling data, values of one or more landmarks of the ear, wherein determining the values of the one or more landmarks comprises:
   predict an ear aperture plane of the ear;
   determine a plurality of cross-sectional planes that are aligned with the ear aperture plane;
   for each of the cross-sectional planes:
      determine an intersection boundary of the cross-sectional plane representing a line of intersection between the cross-sectional plane and the ear; and
      determine a centroid of the intersection boundary of the cross-sectional plane; and
      determine the values of the one or more landmarks based on the centroids.

Clause 20. One or more non-transitory computer-readable storage media having instructions stored thereon that, when executed by one or more processors of a computing system, cause the computing system to:
obtain ear modeling data representing a 3-dimensional (3D) impression of an ear surface of an ear of a patient; and
determine, based on the ear modeling data, values of one or more landmarks of the ear, wherein determining the values of the one or more landmarks comprises:
predict an ear aperture plane of the ear;
determine a plurality of cross-sectional planes that are aligned with the ear aperture plane;
for each of the cross-sectional planes:
   determine an intersection boundary of the cross-sectional plane representing a line of intersection between the cross-sectional plane and the ear; and
   determine a centroid of the intersection boundary of the cross-sectional plane; and
   determine the values of the one or more landmarks based on the centroids.

It is to be recognized that depending on the example, certain acts or events of any of the techniques described herein can be performed in a different sequence, may be added, merged, or left out altogether (e.g., not all described acts or events are necessary for the practice of the techniques). Moreover, in certain examples, acts or events may be performed concurrently, e.g., through multi-threaded processing, interrupt processing, or multiple processors, rather than sequentially.

In one or more examples, the functions described may be implemented in hardware, software, firmware, or any combination thereof. If implemented in software, the functions may be stored on or transmitted over, as one or more instructions or code, a computer-readable medium and executed by a hardware-based processing unit. Computer-readable media may include computer-readable storage media, which corresponds to a tangible medium such as data storage media, or communication media including any medium that facilitates transfer of a computer program from one place to another, e.g., according to a communication protocol. In this manner, computer-readable media generally may correspond to (1) tangible computer-readable storage media which is non-transitory or (2) a communication medium such as a signal or carrier wave. Data storage media may be any available media that can be accessed by one or more computers or one or more processing circuits to retrieve instructions, code and/or data structures for implementation of the techniques described in this disclosure. A computer program product may include a computer-readable medium.

By way of example, and not limitation, such computer-readable storage media can comprise RAM, ROM, EEPROM, CD-ROM or other optical disk storage, magnetic disk storage, or other magnetic storage devices, flash memory, cache memory, or any other medium that can be used to store desired program code in the form of instructions or data structures and that can be accessed by a computer. Also, any connection may be considered a computer-readable medium. For example, if instructions are transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. It should be understood, however, that computer-readable storage media and data storage media do not include connections, carrier waves, signals, or other transient media, but are instead directed to non-transitory, tangible storage media. Combinations of the above should also be included within the scope of computer-readable media.

Functionality described in this disclosure may be performed by fixed function and/or programmable processing circuitry. For instance, instructions may be executed by fixed function and/or programmable processing circuitry. Such processing circuitry may include one or more processors, such as one or more digital signal processors (DSPs), general purpose microprocessors, application specific integrated circuits (ASICs), field programmable logic arrays (FPGAs), or other equivalent integrated or discrete logic circuitry. Accordingly, the term "processor," as used herein may refer to any of the foregoing structure or any other structure suitable for implementation of the techniques described herein. In addition, in some aspects, the functionality described herein may be provided within dedicated hardware and/or software modules. Also, the techniques could be fully implemented in one or more circuits or logic elements. Processing circuits may be coupled to other components in various ways. For example, a processing circuit may be coupled to other components via an internal device interconnect, a wired or wireless network connection, or another communication medium.

Various components, modules, or units are described in this disclosure to emphasize functional aspects of devices configured to perform the disclosed techniques, but do not necessarily require realization by different hardware units. Rather, as described above, various units may be combined in a hardware unit or provided by a collection of interoperative hardware units, including one or more processors as described above, in conjunction with suitable software and/or firmware.

Various examples have been described. These and other examples are within the scope of the following claims.

## Claims

1. A method comprising:
obtaining, by one or more processors implemented in circuitry, ear modeling data representing a 3-dimensional (3D) impression of an ear surface of an ear of a patient; and
determining, by the one or more processors, based on the ear modeling data, values of one or more landmarks of the ear, wherein determining the values of the one or more landmarks comprises:
predicting, by the one or more processors, an ear aperture plane of the ear;
determining, by the one or more processors, a plurality of cross-sectional planes that are aligned with the ear aperture plane;
for each of the cross-sectional planes:
determining, by the one or more processors, an intersection boundary of the cross-sectional plane representing a line of intersection between the cross-sectional plane and the ear; and
determining, by the one or more processors, a centroid of the intersection boundary of the cross-sectional plane; and
determining, by the one or more processors, the values of the one or more landmarks based on the centroids.

2. The method of claim 1, wherein predicting the ear aperture plane comprises applying, by the one or more processors, a trained machine learning (ML) model to the ear modeling data to predict the ear aperture plane.

3. The method of claim 1 or 2, wherein:
the ear modeling data comprises a first point cloud representing the ear surface,
applying the trained ML model comprises:
providing the first point cloud as input to the trained ML model; and
obtaining a second point cloud representing the ear aperture plane as output of the trained ML model.

4. The method of any one of claims 1 to 3, wherein predicting the ear aperture plane comprises:
aligning, by the one or more processors, each of a plurality of ear shape templates with the ear modeling data, wherein each of the ear shape templates has a predefined ear aperture plane;
determining, by the one or more processors, a difference or similarity metric for the aligned ear shape templates;
selecting, by the one or more processors, an ear shape template from the plurality of ear shape templates based on the difference or similarity metric; and
predicting, by the one or more processors, the ear aperture plane based on the predefined ear aperture plane of the selected ear shape template.

5. The method of any one of claims 1 to 4, wherein the landmarks include one or more ear canal landmarks,
preferably wherein the ear canal landmarks include of: a location of a first bend of the ear canal, a location of a second bend of the ear canal, an angle of the first bend of the ear canal, an angle of the second bend of the ear canal, a center line of the ear canal, a length of the ear canal, or a width of the ear canal.

6. The method of any one of claims 1 to 5, wherein the landmarks further include one or more outer ear landmarks and determining the one or more landmarks further comprising determining, based on the ear modeling data, values of the one or more outer ear landmarks of the ear of the patient,
preferably wherein the one or more outer ear landmarks include a position of a helix of the ear, a position of a tragus of the ear, or a volume of a concha of the ear.

7. The method of any one of claims 1 to 6, further comprising:
determining, by the one or more processors, based on the values of the one or more landmarks, whether one or more hearing instrument types are suitable for the patient; and
outputting, by the one or more processors, one or more indications of whether the one or more hearing instrument types are suitable for the patient.

8. The method of any one of claims 1 to 7, further comprising calculating statistical data regarding ears of a population of patients based in part on the values of the landmarks.

9. The method of claim 8, further comprising determining, by the one or more processors, based on the statistical data, a relationship between observed values of the landmarks in the population and returns of hearing instruments provided to the patients in the population; and/or
further comprising generating, by the one or more processors, based on the statistical data and the values of the one or more landmarks, a recommendation regarding whether a specific type of hearing instrument is suitable for the patient.

10. The method of any one of claims 1 to 9, wherein the values of the landmarks are first values of the landmarks, the ear modeling data is first ear modeling data, the first ear modeling data represents the 3D impression of the ear surface while a jaw of the patient is open, and the method further comprises:
obtaining, by the one or more processors, second ear modeling data representing a 3D impression of the ear surface the jaw of the patient is closed; and
determining, by the one or more processors, based on the second ear modeling data, second values of the landmarks.

11. The method of claim 10, further comprising determining, by the one or more processors, a shape of a shell of a hearing instrument based at least in part on the first values of the landmarks and the second values of the landmarks.

12. The method of claim 10 or 11, further comprising calculating, by the one or more processors, statistical data regarding ears of a population of patients based in part on the first values of the landmarks and the second values of the landmarks,
preferably the method further comprises at least one of:
determining, by the one or more processors, based on the statistical data, a correlation between observed values of the landmarks in the population and returns of hearing instruments provided to the patients in the population, or
generating, by the one or more processors, based on the statistical data, the first values of landmarks, and the second values of the landmarks, a recommendation regarding whether a specific type of hearing instrument is suitable for the patient; and/or
preferably the method further comprises at least one of:
determining, by the one or more processors, based on the statistical data, a correlation between observed values of the landmarks in the population and returns of hearing instruments having specific feature sets provided to the patients in the population, or
generating, by the one or more processors, based on the statistical data, the first values of landmarks, and the second values of the landmarks, a recommendation regarding whether a specific feature set is suitable for the patient.

13. The method of any one of claims 1 to 12, further comprising:
determining, by the one or more processors, based on the values of the landmarks, whether the ear modeling data is adequate to generate a device model of a hearing instrument;
based on the ear modeling data being adequate to generate the device model, generating the device model based on the ear modeling data; and
manufacturing the hearing instrument based on the device model.

14. A computing system comprising:
one or more memories configured to store ear modeling data representing a 3-dimensional (3D) impression of an ear surface of an ear of a patient; and
one or more processors implemented in circuitry, the one or more processors configured to determine, based on the ear modeling data, values of one or more landmarks of the ear, wherein determining the values of the one or more landmarks comprises:
predict an ear aperture plane of the ear;
determine a plurality of cross-sectional planes that are aligned with the ear aperture plane;
for each of the cross-sectional planes:
determine an intersection boundary of the cross-sectional plane representing a line of intersection between the cross-sectional plane and the ear; and
determine a centroid of the intersection boundary of the cross-sectional plane; and
determine the values of the one or more landmarks based on the centroids.

15. One or more non-transitory computer-readable storage media having instructions stored thereon that, when executed by one or more processors of a computing system, cause the computing system to:
obtain ear modeling data representing a 3-dimensional (3D) impression of an ear surface of an ear of a patient; and
determine, based on the ear modeling data, values of one or more landmarks of the ear, wherein determining the values of the one or more landmarks comprises:
predict an ear aperture plane of the ear;
determine a plurality of cross-sectional planes that are aligned with the ear aperture plane;
for each of the cross-sectional planes:
determine an intersection boundary of the cross-sectional plane representing a line of intersection between the cross-sectional plane and the ear; and
determine a centroid of the intersection boundary of the cross-sectional plane; and
determine the values of the one or more landmarks based on the centroids.
